# EUROPEAN PATENT APPLICATION

(11) **EP 4 632 818 A1**
(43) Date of publication of application: **15.10.2025**
(21) Application number: 23937918.3
(22) Date of filing: 23.05.2023
(51) Int. Cl.: H01L 27/12, G02F 1/1362

(54) **DISPLAY SUBSTRATE, MANUFACTURING METHOD THEREFOR, AND DISPLAY APPARATUS**

(71) Applicant: Boe Technology Group Co., Ltd., Beijing 100015 (CN); Hefei BOE Joint Technology Co., Ltd., Hefei, Anhui 230012 (CN)
(72) Inventor: LIU, Xiuting, Beijing 100176 (CN); YUAN, Zhidong, Beijing 100176 (CN); LI, Yongqian, Beijing 100176 (CN)
(74) Representative: CMS Cameron McKenna Nabarro Olswang LLP
(86) International application number: PCT/CN2023/095838
(87) International publication number: WO 2024/239244

(57) **Abstract**

A display substrate, a manufacturing method therefor, and a display apparatus. The display substrate comprises a base and a plurality of sub-pixels and a plurality of transparent conductive layers (300) arranged on the base; each sub-pixel comprises at least one transparent conductive layer (300), at least a part of the sub-pixels each at least comprising a second transistor and a third transistor, and a second electrode of the second transistor and a second electrode of the third transistor located in the same sub-pixel being electrically connected by means of at least one transparent conductive layer (300).

## Description

### Technical Field

The present disclosure relates to, but is not limited to, the field of display technologies, and in particular to a display substrate, a preparation method therefor, and a display apparatus.

### Background

An Organic Light Emitting Diode (OLED) is an active light emitting display device, which has advantages such as luminescence, ultra-thinness, a wide angle of view, a high brightness, a high contrast, a relatively low power consumption, an extreme high response speed, or the like. With the continuous development of display technology, OLED technology is increasingly applied in flexible display apparatuses, and has gradually become a next generation display technology with great development prospects. Depending upon different driving modes, OLEDs may be divided into two types, i.e., a Passive Matrix (PM) type and an Active Matrix (AM) type. An AMOLED is a current driven device in which an independent Thin Film Transistor (TFT) is used for controlling each sub-pixel, and each sub-pixel may be continuously and independently driven to emit light.

### Summary

The following is a summary of subject matters described herein in detail. This summary is not intended to limit the protection scope of claims.

In one aspect, the present disclosure provides a display substrate comprising a base substrate, a plurality of sub-pixels and a plurality of transparent conductive layers provided on the base substrate, each sub-pixel comprising at least one transparent conductive layer, at least a portion of the sub-pixels comprising at least a second transistor and a third transistor, a second electrode of the second transistor and a second electrode of the third transistor located in a same sub-pixel being electrically connected through at least one transparent conductive layer.

In an exemplary implementation mode, at least a portion of the transparent conductive layer comprise an anode, a first connection electrode, and a second connection electrode, wherein the anode is electrically connected to the first connection electrode and the second connection electrode in a same transparent conductive layer;

In a same sub-pixel, a second electrode of the second transistor is electrically connected with a corresponding anode through the first connection electrode, a second electrode of the third transistor is electrically connected with a corresponding anode through the second connection electrode, and the second electrode of the second transistor and the second electrode of the third transistor are electrically connected through a corresponding first connection electrode, second connection electrode, and anode.

In an exemplary implementation mode, the first connection electrode and the second connection electrode are of an integrally formed structure with a corresponding anode.

In an exemplary implementation mode, the display substrate further comprising a pixel definition layer, wherein the pixel definition layer is located on a side of the transparent conductive layer away from the base substrate, wherein the pixel definition layer is formed with a plurality of pixel openings, each sub-pixel comprises at least one pixel opening, wherein an orthographic projection of the pixel opening on the base substrate and an orthographic projection of a corresponding anode on the base substrate have an overlapping region, and the transparent conductive layer is located in a light emitting region of a corresponding sub-pixel.

In an exemplary implementation mode, the second electrode of the second transistor is electrically connected to a corresponding first connection electrode through a first transfer via, and an orthographic projection of the first transfer via on the base substrate is within a range of an orthographic projection of the first connection electrode on the base substrate; the second electrode of the third transistor is electrically connected to a corresponding second connection electrode through a second transfer via, and an orthographic projection of the second transfer via on the base substrate is within a range of an orthographic projection of the second connection electrode on the base substrate; a closest distance from the first transfer via to an edge of a corresponding pixel opening is less than a closest distance from the second transfer via to an edge of the corresponding pixel opening, and the first transfer via and the second transfer via are located at two sides of the corresponding pixel opening.

In an exemplary implementation mode, the plurality of sub-pixels are arranged in a row direction and a column direction, in the row direction, a distance between first transfer vias in two adjacent sub-pixels comprises a first distance and a second distance, the first distance being greater than the second distance, the first distance and the second distance being arranged alternately in the row direction.

In an exemplary implementation mode, in the row direction, a distance between second transfer vias in adjacent two sub-pixels comprises a third distance and a fourth distance, the third distance being greater than the fourth distance, the third distance and the fourth distance being arranged alternately in the row direction.

In an exemplary implementation mode, in a same sub-pixel, the second transistor and the third transistor are located at two sides of a corresponding anode in the column direction, and a distance between the second transistor and the third transistor is greater than 0.5 times a size of a sub-pixel in the column direction.

In an exemplary implementation mode, the display substrate further comprising a plurality of data signal lines and a plurality of auxiliary data lines, wherein the plurality of data signal lines are electrically connected to the plurality of auxiliary data lines respectively, the data signal lines and the auxiliary data lines are located on different conductive layers, and in a direction perpendicular to a plane where the display substrate is located, conductive layers where the data signal lines and the auxiliary data lines are located are located between the base substrate and the transparent conductive layers, and orthographic projections of the plurality of data signal lines on the base substrate are at least partially overlapped with orthographic projections of the plurality of auxiliary data lines on the base substrate respectively.

In an exemplary implementation mode, the display substrate comprises a gate metal layer disposed on the base substrate, and at least a portion of the auxiliary data lines are located on the gate metal layer.

In an exemplary implementation mode, the display substrate further comprises a shield metal layer, wherein the gate metal layer is located on a side of the shield metal layer away from the base substrate in the direction perpendicular to the plane where the display substrate is located, and the plurality of data signal lines are located on the shield metal layer.

In an exemplary implementation mode, the shield metal layer is further provided with a plurality of first power supply lines, the gate metal layer is further provided with a plurality of first power supply auxiliary lines, the plurality of first power supply lines are respectively electrically connected with the plurality of first power supply auxiliary lines, and orthographic projections of the plurality of first power supply lines on the base substrate are at least partially overlapped with orthographic projections of the plurality of first power supply auxiliary lines on the base substrate respectively.

In an exemplary implementation mode, the plurality of sub-pixels form a plurality of pixel units arranged in an array, each pixel unit comprises at least three sub-pixels, the gate metal layer is also provided with a plurality of first power supply connection lines, two first power supply auxiliary lines are comprised in a same pixel unit, two ends of a first power supply connection line located in a same pixel unit are respectively connected with the two first power supply auxiliary lines, on a plane parallel to the display substrate, a main body portion of a first power supply auxiliary line extends in a second direction, a main body portion of a first power supply connection line extends in a first direction, and the first direction intersects the second direction.

In an exemplary implementation mode, the display substrate further comprises a semiconductor layer, the semiconductor layer is located on a side of the shield metal layer away from the base substrate in the direction perpendicular to the plane where the display substrate is located, the semiconductor layer is provided with a plurality of compensation connection lines, the shield metal layer is further provided with a plurality of compensation signal lines, and on a plane parallel to the display substrate, a compensation connection line is in a structure of a strip extending in a first direction, a compensation signal line is in a structure of a strip extending in a second direction, the first direction intersects the second direction, and a compensation connection line is electrically connected with at least one compensation signal line.

In an exemplary implementation mode, the display substrate further comprises a source-drain metal layer located on a side of the gate metal layer away from the base substrate in a direction perpendicular to the plane where the display substrate is located, and the plurality of data signal lines are located on the source-drain metal layer.

In an exemplary implementation mode, the display substrate further comprises a second shield metal layer located between the base substrate and the gate metal layer in a direction perpendicular to the plane where the display substrate is located, the plurality of auxiliary data lines comprise a plurality of first auxiliary data lines and a plurality of second auxiliary data lines, the plurality of first auxiliary data lines are located on the second shield metal layer, the plurality of second auxiliary data lines are located on the gate metal layer, orthographic projections of the plurality of first auxiliary data lines and the plurality of second auxiliary data lines on the base substrate and orthographic projections of a corresponding plurality of data signal lines on the base substrate have overlapping regions, and the plurality of first auxiliary data lines and the plurality of second auxiliary data lines are electrically connected with the corresponding plurality of data signal lines.

In an exemplary implementation mode, the source-drain metal layer is further provided with a plurality of first power supply lines, the gate metal layer is further provided with a plurality of first power supply auxiliary lines, the plurality of first power supply lines are respectively electrically connected with the plurality of first power supply auxiliary lines, and orthographic projections of the plurality of first power supply lines on the base substrate are at least partially overlapped with orthographic projections of the plurality of first power supply auxiliary lines on the base substrate.

In an exemplary implementation mode, the plurality of sub-pixels form a plurality of pixel units arranged in an array, each pixel unit comprises at least three sub-pixels, the display substrate further comprises a semiconductor layer, in a direction perpendicular to the plane where the display substrate is located, the semiconductor layer is located on a side of the second shield metal layer away from the base substrate, the semiconductor layer is provided with a plurality of first power supply connection lines, two first power supply lines are comprised in a same pixel unit, two ends of a first power supply connection line located in a same pixel unit are respectively electrically connected with the two first power supply lines, and in a plane parallel to the display substrate, a main body portion of a first power supply line extends in a second direction, a main body portion of a first power supply connection line extends in a first direction, and the first direction intersects the second direction.

In an exemplary implementation mode, the second shield metal layer is further provided with a plurality of compensation connection lines, and the source-drain metal layer is further provided with a plurality of compensation signal lines, on a plane parallel to the display substrate, a compensation connection line is in a structure of a strip extending in a first direction, a compensation signal line is in a structure of a strip extending in a second direction, the first direction intersects the second direction, and a compensation connection line is electrically connected to at least one compensation signal line.

In an exemplary implementation mode, the display substrate further comprises a first shield metal layer located between the base substrate and the second shield metal layer in a direction perpendicular to the plane where the display substrate is located, wherein the first shield metal layer is provided with a plurality of first scan signal lines, the second shield metal layer is provided with a plurality of first scan signal auxiliary lines electrically connected with the plurality of first scan signal lines respectively, and orthographic projections of the plurality of first scan signal lines on the base substrate are at least partially overlapped with orthographic projections of the plurality of first scan signal auxiliary lines on the base substrate, respectively.

In an exemplary implementation mode, a thickness of the first shield metal layer is greater than a thickness of the second shield metal layer.

In an exemplary implementation mode, the display substrate further comprising a first conductive layer located between the base substrate and the transparent conductive layer, a sub-pixel further comprises a capacitor, the first conductive layer comprises a first electrode plate of the capacitor, the first electrode plate has a transparent structure, the anode is reused as a second electrode plate of the capacitor, in a same sub-pixel, an orthographic projection of the first electrode plate on the base substrate and an orthographic projection of the second electrode plate on the base substrate have a first overlapping region, and the first overlapping region is located in a light emitting region of the sub-pixel.

In an exemplary implementation mode, the display substrate further comprising a first conductive layer located between the base substrate and the transparent conductive layer, a sub-pixel further comprises a capacitor, the first conductive layer comprises a first electrode plate of the capacitor, the first electrode plate has a transparent structure;

The display substrate further comprises a gate metal layer, wherein the transparent conductive layer is located in the gate metal layer, and the transparent conductive layer is reused as a second electrode plate of the capacitor, wherein an orthographic projection of the first electrode plate on the base substrate and an orthographic projection of the second electrode plate on the base substrate have a first overlapping region, wherein the first overlapping region is located in a light emitting region of the sub-pixel.

In another aspect, the present disclosure also provides a display apparatus, including the display substrate described above.

In yet another aspect, the present disclosure also provides a preparation method for a display substrate, comprising: forming a plurality of sub-pixels and a plurality of transparent conductive layers on a side of a base substrate, wherein at least a portion of the sub-pixels comprise at least a second transistor and a third transistor, and a second electrode of the second transistor and a second electrode of the third transistor located in a same sub-pixel are electrically connected through at least one transparent conductive layer.

Other aspects may be comprehended upon reading and understanding drawings and detailed description.

### Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of various components in the drawings do not reflect actual scales, but are only intended to schematically illustrate contents of the present disclosure.
FIG.1 is a schematic diagram of a structure of a display apparatus.
FIG. 2 is a schematic diagram of a planar structure of a display substrate.
FIG. 3 is a schematic diagram of a sectional structure of a display substrate.
FIG. 4 is a schematic diagram of an equivalent circuit of a pixel drive circuit.
FIG. 5a is a schematic diagram of a structure of a display substrate according to an exemplary embodiment of the present disclosure.
FIG. 5b is a schematic diagram of a structure of a display substrate according to an exemplary embodiment of the present disclosure.
FIG. 5c is an equivalent circuit diagram of the pixel drive circuit in the four sub-pixels shown in FIG. 5a and FIG. 5b.
FIG. 6 is a schematic diagram after a pattern of a first conductive layer is formed according to an exemplary embodiment of the present disclosure.
FIG. 7a is a schematic diagram after a pattern of a second conductive layer is formed according to an exemplary embodiment of the present disclosure;
FIG. 7b is a schematic plan view of the second conductive layer in FIG. 7a.
FIG. 8a is a schematic diagram after a pattern of a semiconductor layer is formed according to an exemplary embodiment of the present disclosure.
FIG. 8b is a schematic plan view of the semiconductor layer in FIG. 8a.
FIG. 9 is a schematic diagram obtained after a pattern of a second insulation layer is formed according to an exemplary embodiment of the present disclosure.
FIG. 10a is a schematic diagram after a pattern of a third conductive layer is formed according to an exemplary embodiment of the present disclosure;
FIG. 10b is a schematic plan view of the third conductive layer in FIG. 10a.
FIG. 10c is a schematic diagram of a cross-section structure at a position A1-A1 in FIG. 10a.
FIG. 10d is a schematic diagram of a cross-section structure at a position A2-A2 in FIG. 10a.
FIG. 11 is a schematic diagram after a pattern of a planarization layer is formed according to an exemplary embodiment of the present disclosure.
FIG. 12a is a schematic diagram after a pattern of a fourth conductive layer is formed according to an exemplary embodiment of the present disclosure.
FIG. 12b is a schematic plan view of the fourth conductive layer in FIG. 12a.
FIG. 13a is a schematic diagram after a pattern of a pixel definition layer is formed according to an exemplary embodiment of the present disclosure.
FIG. 13b is a schematic plan view of the pixel definition layer in FIG. 13a.
FIG. 14 is a schematic diagram after a pattern of a first conductive layer is formed according to an exemplary embodiment of the present disclosure.
FIG. 15 is a schematic diagram after a pattern of a second conductive layer is formed according to an exemplary embodiment of the present disclosure.
FIG. 16a is a schematic diagram after a pattern of a third conductive layer is formed according to an exemplary embodiment of the present disclosure;
FIG. 16b is a schematic plan view of the third conductive layer in FIG. 16a.
FIG. 17a is a schematic diagram after a pattern of a semiconductor layer is formed according to an exemplary embodiment of the present disclosure.
FIG. 17b is a schematic plan view of the semiconductor layer in FIG. 17a.
FIG. 18a is a schematic diagram after a pattern of a fourth conductive layer is formed according to an exemplary embodiment of the present disclosure.
FIG. 18b is a schematic plan view of the fourth conductive layer in FIG. 18a.
FIG. 19 is a schematic diagram after a pattern of a third insulation layer is formed according to an exemplary embodiment of the present disclosure.
FIG. 20a is a schematic diagram after a pattern of a fifth conductive layer is formed according to an exemplary embodiment of the present disclosure.
FIG. 20b is a schematic plan view of the fifth conductive layer in FIG. 20a;
FIG. 21 is a schematic diagram after a pattern of a planarization layer is formed according to an exemplary embodiment of the present disclosure.
FIG. 22a is a schematic diagram after a pattern of a sixth conductive layer is formed according to an exemplary embodiment of the present disclosure;
FIG. 22b is a schematic plan view of the sixth conductive layer in FIG. 20a; and
FIG. 23a is a schematic diagram after a pattern of a pixel definition layer is formed according to an exemplary embodiment of the present disclosure.
FIG. 23b is a schematic plan view of the pixel definition layer in FIG. 23a.
FIG. 23c is a schematic diagram of a cross-section structure at a position A3-A3 in FIG. 22a.
FIG. 24a is a schematic plan view of a semiconductor layer according to an exemplary embodiment of the present disclosure;
FIG. 24b is a schematic diagram after forming a pattern of a fourth conductive layer according to an exemplary embodiment of the present disclosure.
FIG. 24c is a schematic plan view of the fourth conductive layer in FIG. 24b.
FIG. 24d is a schematic diagram after forming a pattern of a third insulation layer according to an exemplary embodiment of the present disclosure.
FIG. 24e is a schematic diagram after a pattern of a fifth conductive layer is formed according to an exemplary embodiment of the present disclosure.
FIG. 24f is a schematic plan view of the fifth conductive layer in FIG. 24e;
FIG. 25a is a schematic diagram after a pattern of a fourth conductive layer is formed according to an exemplary embodiment of the present disclosure.
FIG. 25b is a schematic diagram after a pattern of a fifth conductive layer is formed according to an exemplary embodiment of the present disclosure.
FIG. 25c is a schematic diagram after a pattern of a sixth conductive layer is formed according to an exemplary embodiment of the present disclosure;

### Detailed Description

To make the objectives, technical solutions, and advantages of the present disclosure clearer, the embodiments of the present disclosure will be described in detail below with reference to the accompany drawings. Implementation modes may be implemented in multiple different forms. Those of ordinary skills in the art can easily understand such a fact that implementation modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between composition elements.

**In** the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification.

In the specification, "electrical connection" includes connection of composition elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In the present disclosure, "about" refers to that a boundary is not defined so strictly and numerical values within a range of process and measurement errors are allowed.

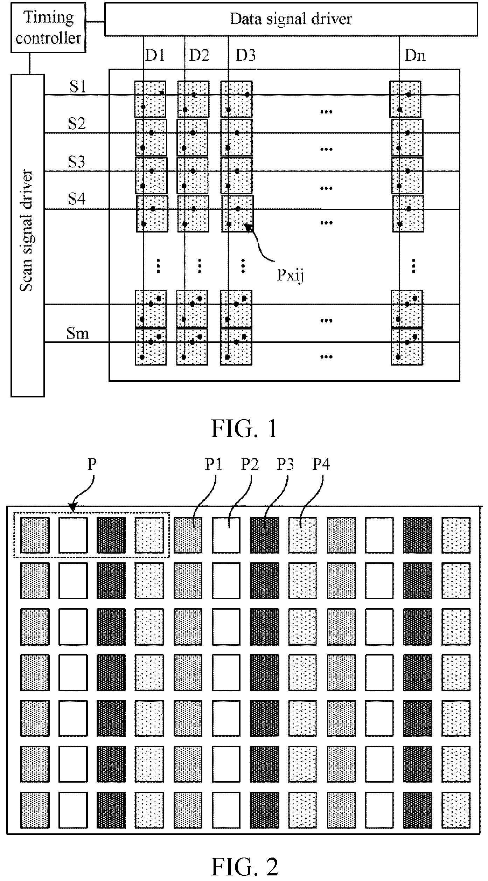

FIG. 1 is a schematic diagram of a structure of a display apparatus. As shown in FIG. 1, the display apparatus may include a timing controller, a data driver, a scan driver, and a pixel array. The timing controller is connected to the data driver and the scan driver respectively, the data driver is connected to multiple data signal lines (D1 to D) respectively, and the scan driver is connected to multiple scan signal lines (S1 to Sm) respectively. The pixel array may include multiple sub-pixels Pxij, wherein i and j may be natural numbers. At least one sub-pixel Pxij may include a circuit unit and a light emitting device connected to the circuit unit, wherein the circuit unit may include at least one scan signal line, at least one data signal line and a pixel drive circuit. In an exemplary embodiment, the timing controller may provide a control signal and a gray scale value suitable for the specification of the data driver to the data driver, and may provide a scan start signal, a clock signal suitable for the specification of the scan driver and the like to the scan driver. The data driver may generate data voltages to be provided to the data signal lines D1, D2, D3, ..., and D using the grayscale value and the control signal that are received from the timing controller. For example, the data driver may sample the gray scale value by using a clock signal, and apply a data voltage corresponding to the gray scale value to the data signal lines D1 to D by taking a pixel row as a unit, wherein n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting a scan start signal provided in a form of an on level pulse to a next-stage circuit under control of the clock signal, wherein m may be a natural number.

FIG. 2 is a schematic diagram of a planar structure of a display substrate. As shown in FIG. 2, the display substrate may include multiple pixel units P arranged in a matrix manner. At least one of the multiple pixel units P includes a first sub-pixel P1 emitting a first color light, a second sub-pixel P2 emitting a second color light, a third sub-pixel P3 emitting a third color light and a fourth sub-pixel P4 emitting a fourth color light. The four sub-pixels may each include a circuit unit and a light emitting device. The circuit unit may include a scan signal line, a data signal line and a pixel drive circuit. The pixel drive circuit is respectively connected to the scan signal line and the data signal line. The pixel drive circuit is configured to receive the data voltage transmitted by the data signal line and output a corresponding current to the light emitting device under the control of the scan signal line. The light emitting device in each sub-pixel is connected with a pixel drive circuit of a sub-pixel where the light emitting device is located, and is configured to emit light with corresponding brightness in response to a current output by the pixel drive circuit of the sub-pixel where the light emitting device is located.

In an exemplary implementation mode, the first sub-pixel P1 may be a Red sub-pixel (R) emitting red light, the second sub-pixel P2 may be a White sub-pixel (W) emitting white light, the third sub-pixel P3 may be a Blue sub-pixel (B) emitting blue light, and the fourth sub-pixel P4 may be a Green sub-pixel (G) emitting green light.

In exemplary embodiments, the sub-pixel may have a shape of a rectangle, a rhombus, a pentagon, or a hexagon. In an exemplary implementation mode, the four sub-pixels may be arranged in a horizontal side-by-side manner to form an RWBG pixel arrangement. In another exemplary implementation, the four sub-pixels may be arranged in a square, diamond, vertical side-by-side manner or the like, which is not limited here in the present disclosure.

In an exemplary embodiment, multiple sub-pixels sequentially arranged in the horizontal direction are referred to as a pixel row, and multiple sub-pixels sequentially arranged in the vertical direction are referred to as a pixel column; the multiple pixel rows and the multiple pixel columns together form a pixel array arranged in an array.

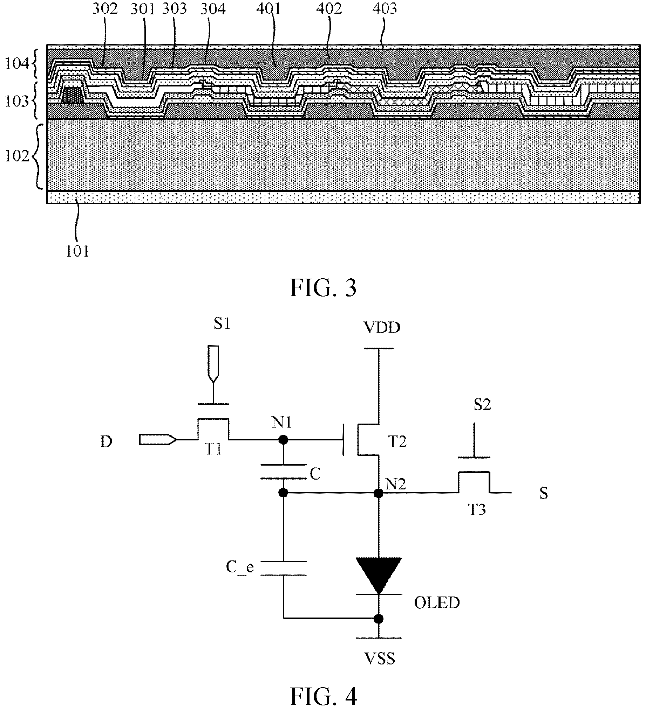

FIG. 3 is a schematic diagram of a sectional structure of a display substrate, and illustrates a structure of four sub-pixels of the display substrate. As shown in FIG. 3, on a plane perpendicular to the display substrate, each sub-pixel of the display substrate may include a drive circuit layer 102 disposed on a base substrate 101, a light emitting structure layer 103 disposed at a side of the drive circuit layer 102 away from the base substrate, and an encapsulation layer 104 disposed at a side of the light emitting structure layer 103 away from the base substrate.

In an exemplary implementation mode, the base substrate 101 may be a flexible base substrate, or may be a rigid base substrate. The drive circuit layer 102 of each sub-pixel may include a pixel drive circuit composed of a plurality of transistors and a storage capacitor. The emitting structure layer 103 of each sub-pixel may include a light-emitting device composed of multiple film layers, and the multiple film layers may include an anode 301, a pixel definition layer 302, an organic emitting layer 303 and a cathode 304. The anode 301 is connected to the pixel drive circuit, the organic emitting layer 303 is connected to the anode 301, the cathode 304 is connected to the organic emitting layer 303, the organic emitting layer 303 emits light of a corresponding color under driving of the anode 301 and the cathode 304. The encapsulation layer 104 may include a first encapsulation layer 401, a second encapsulation layer 402, and a third encapsulation layer 403 that are stacked. The first encapsulation layer 401 and the third encapsulation layer 403 may be made of an inorganic material, the second encapsulation layer 402 may be made of an organic material, and the second encapsulation layer 402 is disposed between the first encapsulation layer 401 and the third encapsulation layer 403 so as to prevent external water vapor from entering the light-emitting structure layer 103.

In an exemplary implementation mode, the organic light emitting layer may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL). In an exemplary implementation mode, the hole injection layer, the hole transport layer, the electron block layer, the hole block layer, the electron transport layer and the electron injection layer of all sub-pixels may be connected together to form a common layer, and the emitting layers of all sub-pixels may be connected together to form a common layer, or may be isolated from each other, and the emitting layers of adjacent sub-pixels may overlap slightly. In some possible implementations, the display substrate may include other film layers, and the present disclosure is not limited thereto.

In an exemplary implementation mode, the pixel drive circuit may have a structure of 3TIC, 4T1C, 5T1C, 5T2C, 6T1C, 7T1C, or 8T1C. FIG. 4 is a schematic diagram of an equivalent circuit of a pixel drive circuit. As shown in FIG. 4, the pixel drive circuit has a structure of 3T1C, which may include three transistors (a first transistor T1, a second transistor T2, and a third transistor T3), one storage capacitor C, and six signal lines (a data signal line D, a first scan signal line S1, a second scan signal line S2, a compensation signal line S, a first power supply line VDD, and a second power supply line VSS). C_e in FIG. 4 is an OLED intrinsic capacitance.

In an exemplary implementation mode, the first transistor T1 is a switch transistor, the second transistor T2 is a drive transistor, and the third transistor T3 is a compensation transistor. A first electrode of the storage capacitor C is coupled to a control electrode of the second transistor T2, a second electrode of the storage capacitor C is coupled to a second electrode of the second transistor T2, and the storage capacitor C is configured to store a potential of the control electrode of the second transistor T2. A control electrode of the first transistor T1 is coupled to the first scan signal line S1, a first electrode of the first transistor T1 is coupled to the data signal line D, a second electrode of the first transistor T1 is coupled to the control electrode of the second transistor T2. The first transistor T1 is configured to receive a data signal transmitted by the data signal line D under control of the first scan signal line S1, so that the control electrode of the second transistor T2 receives the data signal. The control electrode of the second transistor T2 is coupled to a second electrode of the first transistor T1, a first electrode of the second transistor T2 is coupled to the first power supply line VDD, the second electrode of the second transistor T2 is coupled to a first electrode of a light emitting device, and the second transistor T2 is configured to generate a corresponding current at its second electrode under control of the data signal received by the control electrode of the second transistor. A control electrode of the third transistor T3 is coupled to the second scan signal line S2, a first electrode of the third transistor T3 is coupled to the compensation signal line S, a second electrode of the third transistor T3 is coupled to the second electrode of the second transistor T2. The third transistor T3 is configured to extract a threshold voltage Vth and a mobility of the second transistor T2 in response to compensation timing to compensate the threshold voltage Vth.

In an exemplary implementation mode, the light emitting device may be an OLED, including a first electrode (anode), an organic emitting layer, and a second electrode (cathode) which are stacked. The first electrode of the OLED is coupled to the second electrode of the second transistor T2, a second electrode of the OLED is coupled to the second power supply line VSS, and the OLED is configured to emit light with corresponding brightness in response to the current of the second electrode of the second transistor T2.

In an exemplary implementation mode, a signal of the first power supply line VDD is a high-level signal continuously provided, and a signal of the second power supply line VSS is a low-level signal. The first transistor T1 to the third transistor T3 may be P-type transistors or may be N-type transistors. Use of a same type of transistors in a pixel drive circuit may simplify a process flow, reduce a process difficulty of a display panel, and improve a product yield.

In an exemplary implementation mode, for the first transistor T1 to the third transistors T3, low temperature poly silicon thin film transistors may be used, oxide thin film transistors may be used, or low temperature poly silicon thin film transistors and oxide thin film transistors may be used. An active layer of a low temperature poly silicon thin film transistor is made of Low Temperature Poly Silicon (LTPS for short), and an active layer of an oxide thin film transistor is made of an oxide. The low temperature poly silicon thin film transistor has advantages of a high mobility, fast charging, and the like. The oxide thin film transistor has advantages of a low leakage current and the like. In an exemplary implementation mode, a low temperature poly silicon thin film transistor and an oxide thin film transistor may be integrated on one display substrate to form a Low Temperature Polycrystalline Oxide (LTPO for short) display substrate, so that advantages of the two types of thin film transistors may be utilized, high Pixel Per Inch (PPI for short) and low-frequency drive may be achieved, power consumption may be reduced, and display quality may be improved. In an exemplary implementation mode, the light emitting device may be an Organic Light Emitting Diode (OLED) including a first electrode (anode), an organic emitting layer, and a second electrode (cathode) that are stacked.

In an exemplary implementation mode, taking that all three transistors are N-type transistors as an example, an operation process of the pixel drive circuit illustrated in FIG. 4 may include:
In a first stage A1, signals of the first scan signal line S1 and the second scan signal line S2 are high level signals, the data signal line D outputs a data voltage, the compensation signal line S outputs a compensation voltage, a signal of the first power supply line VDD is at a high level, and a signal of the second power supply line VSS is at a low level. The signal of the first scan signal line S1 is a high level signal, so that the first transistor T1 is turned on, the data voltage output by the data signal line D is written into the first node N1, a potential of the first node N1 is pulled up, and the storage capacitor C is charged. At this time, the potential of the first node N1 is V₁=V_{data}. The signal of the second scan signal line S2 is a high level signal, so that the third transistor T3 is turned on, and the compensation voltage output by the compensation signal line S is written to the second node N2. At this time, a potential the potential of the second node N2 is V₂=Vₛ. Since a potential difference between the first node N1 and the second node N2 is greater than a threshold voltage Vₜₕ of the second transistor T2, the second transistor T2 is turned on. A power supply voltage output from the first power supply line VDD provides a driving voltage to the first electrode of the OLED through the turned-on second transistor T2 to drive the OLED to emit light.
In a second stage A2, signals of the first scan signal line S1 and the second scan signal line S2 are low-level signals, so that the first transistor T1 and the third transistor T3 are turned off, a voltage in the storage capacitor C is still such that the second transistor T2 in a turned-on state, and the power supply voltage output from the first power supply line VDD continuously pulls up the potential of the second node N2. Due to the existence of the storage capacitor C, the potential of the first node N1 will rise with the increase of the potential of the second node N2, and the OLED continues to emit light until the data voltage is written next time.

In an exemplary implementation mode, to drive the OLED to emit light normally, the OLED and the second transistor T2 are both forward biased. In the first stage, the supply voltage output by the first power supply line VDD is greater than the data voltage output by the data signal line D, the data voltage output by the data signal line D is greater than the compensation voltage output by the compensation signal line S, and the compensation voltage output by the compensation signal line S is greater than the supply voltage output by the second power supply line VSS.

As a size of the display substrate increases, the in-plane resistance capacitance (RC for short) has an increased effect on the charging rate, and its charging rate uniformity is poor. The RC that affects the uniformity of the in-plane charging rate includes at least one of the following: a RC brought by the first power supply line (VDD RC for short), a RC brought by the scan line (Gate RC for short), and a RC brought by the data line (that is, the data signal line) (Data RC for short). In addition, the electrode plate of the capacitor and the circuit trace in the display substrate take up a certain amount of space, so that the aperture ratio of the display substrate is not high, and the pixels per inch (PPI) is low, which greatly affects the display effect of the display substrate; an anode via is usually provided at one end of a sub-pixel, and there is a problem of uneven display at two ends of the sub-pixel.

An embodiment of the present disclosure provides a display substrate, which may include a base substrate, a plurality of sub-pixels and a plurality of transparent conductive layers provided on the base substrate, each sub-pixel comprising at least one transparent conductive layer, at least a portion of the sub-pixels comprising at least a second transistor and a third transistor, a second electrode of the second transistor and a second electrode of the third transistor located in a same sub-pixel being electrically connected through at least one transparent conductive layer.

In the display substrate according to the present embodiment, a second electrode of the second transistor and a second electrode of the third transistor located in a same sub-pixel are electrically connected by at least one transparent conductive layer, and the transparent conductive layer does not shield the aperture, so that the aperture ratio and PPI of the display substrate can be improved.

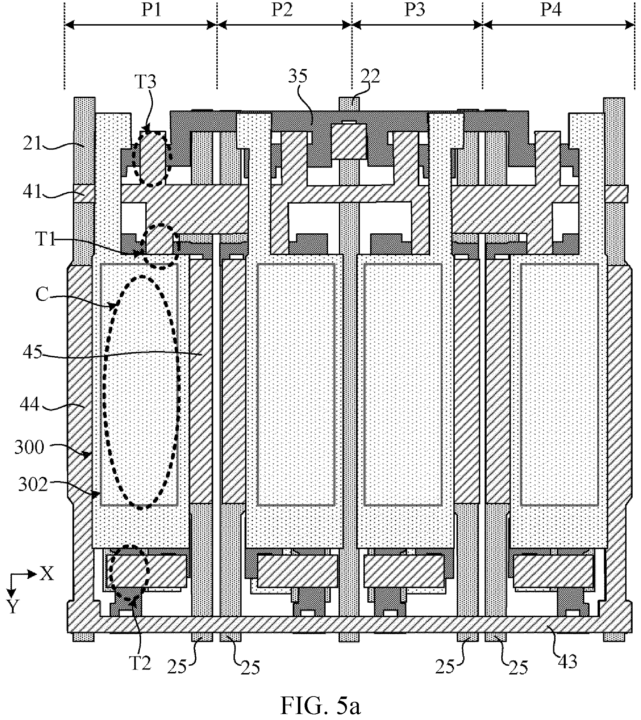

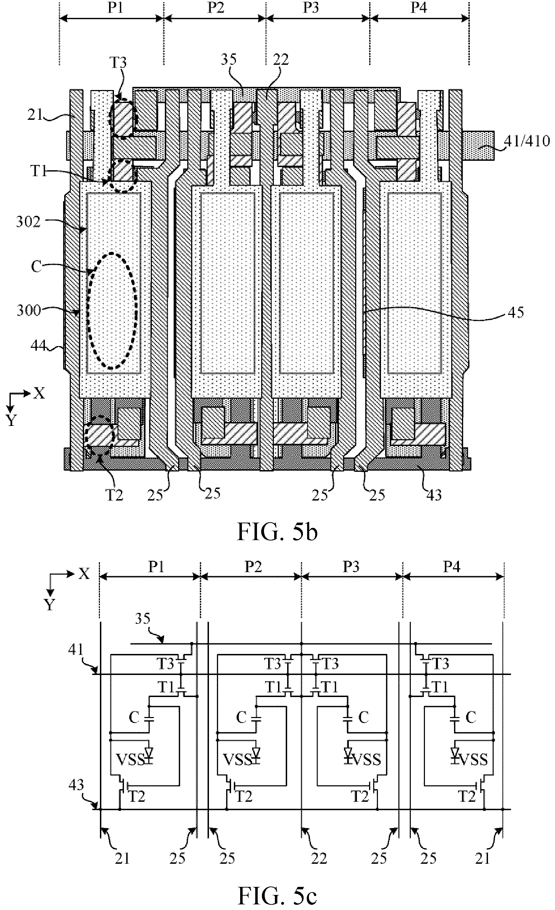

FIGS. 5a and 5b are schematic diagrams of a structure of a display substrate according to an exemplary embodiment of the present disclosure. The display substrate may include a base substrate and a plurality of sub-pixels and a plurality of transparent conductive layers 300 disposed on the base substrate. Each sub-pixel includes at least one transparent conductive layer 300. At least a portion of the sub-pixels include at least a second transistor T2 and a third transistor T3. A second electrode of the second transistor T2 and a second electrode of the third transistor T3 located in a same sub-pixel are electrically connected through at least one transparent conductive layer 300.

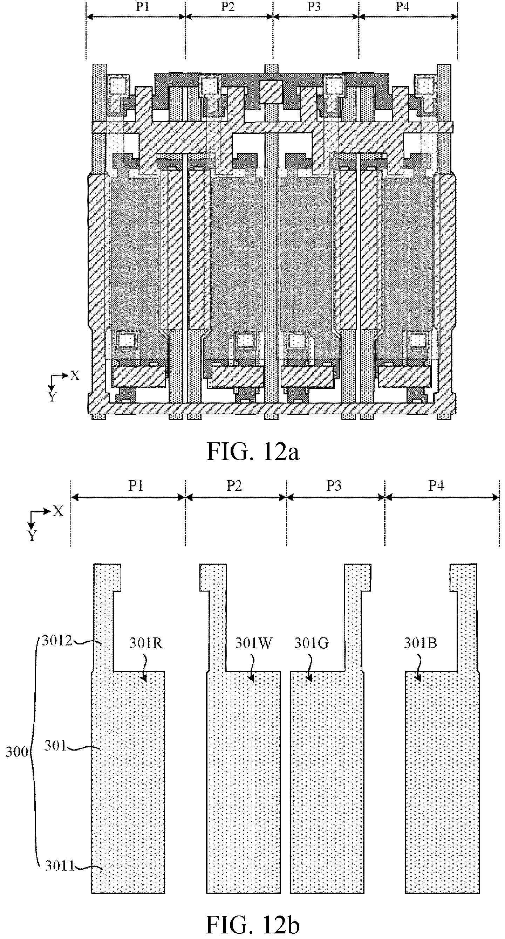

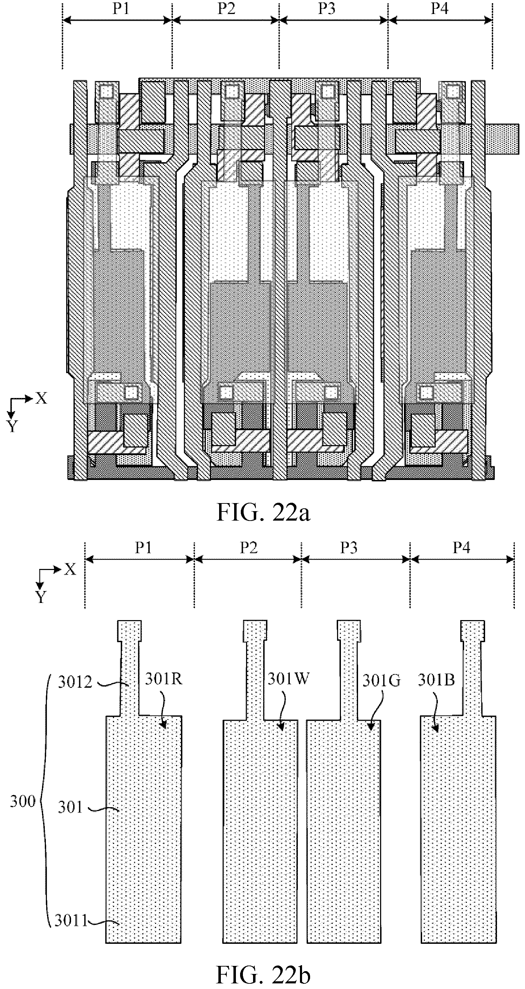

In an exemplary implementation mode, as shown in FIGS. 12b and 22b, at least a portion of the transparent conductive layers 300 include an anode 301, a first connection electrode 3011, and a second connection electrode 3012, and the anode 301 is electrically connected to the first connection electrode 3011 and the second connection electrode 3012 in a same transparent conductive layer 300;
In a same sub-pixel, a second electrode of the second transistor T2 is electrically connected to a corresponding anode 301 through the first connection electrode 3011, a second electrode of the third transistor T3 is electrically connected to the corresponding anode 301 through the second connection electrode 3012, and the second electrode of the second transistor T2 and the second electrode of the third transistor T3 are electrically through a corresponding first connection electrode 3011, second connection electrode 3012, and anode 301.

In an exemplary implementation mode, as shown in FIGS. 12b and 22b, the first connection electrode 3011 and the second connection electrode 3012 and the corresponding anode 301 are of an integrally formed structure. In an exemplary implementation mode, the first connection electrode 3011, the second connection electrode 3012, and the anode 301 in the transparent conductive layer 300 are all transparent conductive structures, which do not take up the pixel aperture ratio and do not shield the aperture, thereby improving the aperture ratio and PPI of the display substrate.

In an exemplary implementation mode, as shown in FIGS. 5a, 5b, 13b, and 23b, the display substrate may further include a pixel definition layer located on a side of the transparent conductive layer away from the base substrate, the pixel definition layer is formed with a plurality of pixel openings 302, each sub-pixel includes at least one pixel opening 302, an orthographic projection of the pixel opening 302 on the base substrate and an orthographic projection of a corresponding anode 301 on the base substrate have an overlapping region, and the transparent conductive layer 300 is located in a light emitting region of a corresponding sub-pixel. In an embodiment of the present disclosure, the transparent conductive layer 300 is located in a light emitting region of a sub-pixel, and since the transparent conductive layer 300 is of a transparent structure, it does not shield the light emission of the sub-pixel. In an exemplary implementation mode, a region corresponding to the pixel opening 302 in a sub-pixel may be a light emitting region of the sub-pixel.

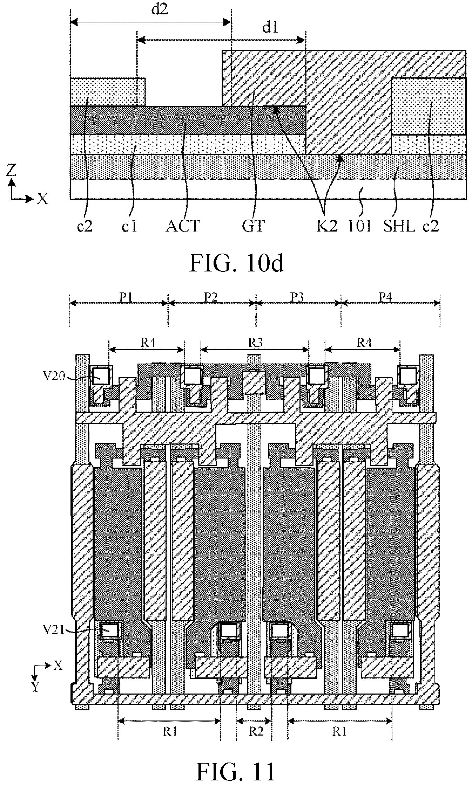

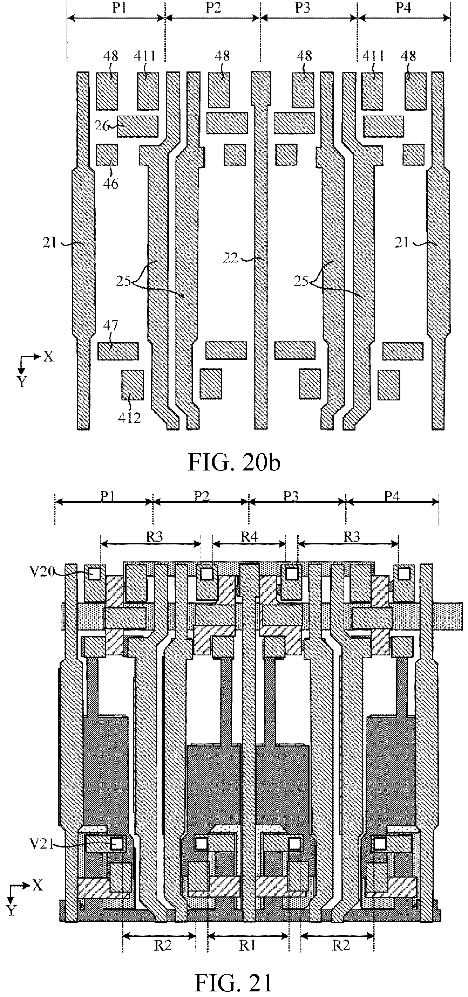

In an exemplary implementation mode, as shown in FIGS. 11 and 21, a second electrode of the second transistor T2 is electrically connected to a corresponding first connection electrode 3011 through a first transfer via V21, and an orthographic projection of the first transfer via V21 on the base substrate is within a range of an orthographic projection of the first connection 3011 electrode on the base substrate; a second electrode of the third transistor T3 is electrically connected to a corresponding second connection electrode 3012 through a second transfer via V20, and an orthographic projection of the second transfer via V20 on the base substrate is within a range of an orthographic projection of the second connection electrode 3012 on the base substrate; the closest distance from the first transfer via V21 to an edge of a corresponding pixel opening 302 is less than the closest distance from the second transfer via V21 to an edge of the corresponding pixel opening 302, and the first transfer via V21 and the second transfer via V20 are located at two sides of the corresponding pixel opening 302. In an embodiment of the present disclosure, the first transfer via V21 and the second transfer via V20 are located at two sides of the corresponding pixel opening 302 as anode vias, so that uneven display at two ends of the sub-pixel due to the transfer vias being located at one of sides of the pixel opening 302 can be prevented, and the display uniformity can be improved.

In an exemplary implementation mode, as shown in FIGS. 11 and 21, a plurality of sub-pixels may be arranged in a row direction X and a column direction Y, in the row direction X, the distance between the first transfer vias V21 in adjacent two sub-pixels includes a first distance R1 and a second distance R2, the first distance R1 is greater than the second distance R2, the first distance R1 and the second distance R2 are arranged alternately in the row direction X. As shown in FIG. 11, the distance between the first transfer via V21 in the first sub-pixel P1 and the first transfer via V21 in the second sub-pixel P2, the distance between the first transfer via V21 in the third sub-pixel P3 and the first transfer via V21 in the fourth sub-pixel P4 are the first distance R1, and the distance between the first transfer via V21 in the second sub-pixel P2 and the first transfer via V21 in the third sub-pixel P3 is the second distance R2; as shown in FIG. 21, the distance between the first transfer via V21 in the first sub-pixel P1 and the first transfer via V21 in the second sub-pixel P2, the distance between the first transfer via V21 in the third sub-pixel P3 and the first transfer via V21 in the fourth sub-pixel P4 are the second distance R2, and the distance between the first transfer via V21 in the second sub-pixel P2 and the first transfer via V21 in the third sub-pixel P3 is the first distance R1.

In an exemplary implementation mode, as shown in FIGS. 11 and 21, in the row direction X, the distance between the second transfer vias V20 in adjacent two sub-pixels includes a third distance R3 and a fourth distance R4, the third distance R3 is greater than the fourth distance R4, and the third distance R3 and the fourth distance R4 are arranged alternately in the row direction X. As shown in FIG. 11, the distance between the second transfer via V20 in the first sub-pixel P1 and the second transfer via V20 in the second sub-pixel P2, the distance between the second transfer via V20 in the third sub-pixel P3 and the second transfer via V20 in the fourth sub-pixel P4 are the fourth distance R4, and the distance between the second transfer via V20 in the second sub-pixel P2 and the second transfer via V20 in the third sub-pixel P3 is the third distance R3; as shown in FIG. 21, the distance between the second transfer via V20 in the first sub-pixel P1 and the second transfer via V20 in the second sub-pixel P2, the distance between the second transfer via V20 in the third sub-pixel P3 and the second transfer via V20 in the fourth sub-pixel P4 are the third distance R3, and the distance between the second transfer via V20 in the second sub-pixel P2 and the second transfer via V20 in the third sub-pixel P3 is the fourth distance R4.

In an exemplary implementation mode, as shown in FIGS. 5a and 5b, in a same sub-pixel, the second transistor T2 and the third transistor T3 are located at two sides of the corresponding anode 301 in the column direction X, and the distance between the second transistor T2 and the third transistor T3 is greater than 0.5 times a size of the sub-pixel in the column direction Y.

In an exemplary implementation mode, as shown in FIGS. 5a, 5b, 6 and 15, the display substrate may further include a first conductive layer located between the base substrate and the transparent conductive layer 300, and the sub-pixel may further include a capacitor, the first conductive layer may include a first electrode plate 11 of the capacitor, and the first electrode plate 11 has a transparent structure. In an embodiment of the present disclosure, the first electrode plate 11 of the capacitor is provided with a transparent structure, which can prevent the shield of the pixel opening, thereby improving the aperture ratio and PPI of the display substrate.

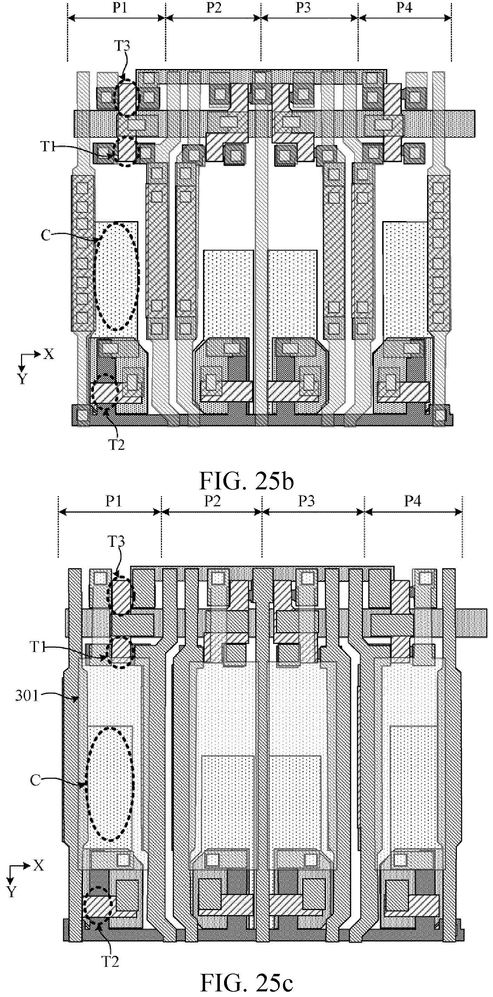

In an exemplary implementation mode, as shown in FIG. 25c, the anode 301 may be reused as a second electrode plate of the capacitor, and in a same sub-pixel, an orthographic projection of the first electrode plate 11 on the base substrate and an orthographic projection of the second electrode plate on the base substrate have a first overlapping region, the first overlapping region being located in the light emitting region of the sub-pixel. The light emitting region of the sub-pixel corresponds to the corresponding pixel opening 302, or an orthographic projection of the light emitting region on the base substrate overlaps an orthographic projection of the corresponding pixel opening 302 on the base substrate. In the structure shown in FIG. 25c, the first electrode plate 11 in the first conductive layer and the anode 301 reused as the second electrode plate in the transparent conductive layer are both of a transparent structure, so that two electrode plates of the capacitor do not take up the aperture ratio of the display substrate, thereby greatly improving the aperture ratio and PPI of the display substrate.

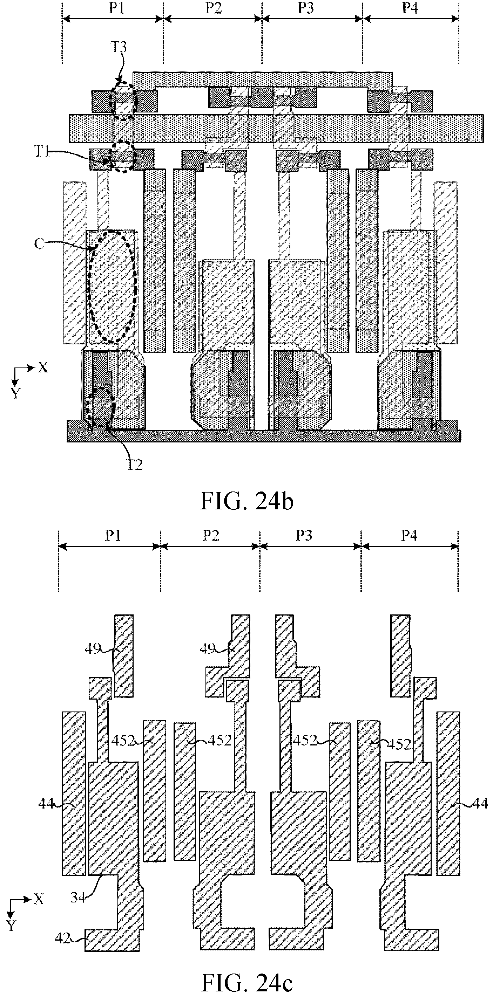

In an exemplary implementation mode, as shown in FIGS. 24b and 24c, the display substrate may also include a gate metal layer, the transparent conductive layer 300 may be located in the gate metal layer, the transparent conductive layer 300 may be reused as a second electrode plate of the capacitor, and an orthographic projection of the first electrode plate 11 on the base substrate and an orthographic projection of the second electrode plate on the base substrate have a first overlapping region, and the first overlapping region is located in the light emitting region of the sub-pixel. In the structures shown in FIGS. 24b and 24c, the first electrode plate 11 in the first conductive layer and the transparent conductive layer 30 reused as the second electrode plate are both of a transparent structure, so that two electrode plates of the capacitor do not take up the aperture ratio of the display substrate, thereby greatly improving the aperture ratio and PPI of the display substrate.

In an exemplary implementation mode, as shown in FIGS. 5a and 5b, the display substrate may further include a plurality of data signal lines 25 and a plurality of auxiliary data lines 45, the plurality of data signal lines 25 are electrically connected to the plurality of auxiliary data lines 45 respectively, the data signal lines 25 and the auxiliary data lines 45 are located on different conductive layers, the conductive layers on which the data signal lines 25 and the auxiliary data lines 45 are located are located between the base substrate and the transparent conductive layer 300 in a direction perpendicular to the plane where the display substrate is located, and orthographic projections of the plurality of data signal lines 25 on the base substrate are at least partially overlapped with orthographic projections of the plurality of auxiliary data lines 45 on the base substrate, respectively.

In an embodiment of the present disclosure, by electrically connecting the data signal lines and the auxiliary data lines located one different conductive layers, the RC of the data signal lines are reduced, and the charging uniformity of the display substrate is improved.

FIG. 5a and FIG. 5b are schematic diagrams of a structure of a display substrate according to an exemplary embodiment of the present disclosure, illustrating a structure of a drive circuit layer in four sub-pixels (one pixel unit) of a bottom emission display substrate, and FIG. 5c is an equivalent circuit diagram of the pixel drive circuit in the four sub-pixels shown in FIG. 5a and FIG. 5b. As shown in FIGS. 5a to 5c, in a direction parallel to the display substrate, at least one pixel unit may include a first sub-pixel P1, a second sub-pixel P2, a third sub-pixel P3, and a fourth sub-pixel P4 arranged in order along the first direction X, and each sub-pixel includes a pixel drive circuit and a storage capacitor. In the following description, the sub-pixels refer to regions in which the pixel drive circuits are provided. In an exemplary embodiment, the at least one pixel unit may further include one first scan signal line 41, two first power supply lines 21, four data signal lines 25, one compensation signal line 22, and four pixel drive circuits.

As shown in FIGS. 5a and 5b, the display substrate according to an embodiment of the present disclosure may include a base substrate, a plurality of data signal lines 25 and a plurality of auxiliary data lines 45 provided on the base substrate, the plurality of data signal lines 25 are electrically connected to the plurality of auxiliary data lines 45, respectively, the data signal lines 25 and the auxiliary data lines 45 are located on different conductive layers, and orthographic projections of the plurality of data signal lines 25 on the base substrate overlap at least partially with orthographic projections of the plurality of auxiliary data lines 45 on the base substrate, respectively.

In an exemplary implementation mode, as shown in FIGS. 5a and 5b, the display substrate may include a gate metal layer disposed on the base substrate on which at least a portion of the auxiliary data lines 45 are located.

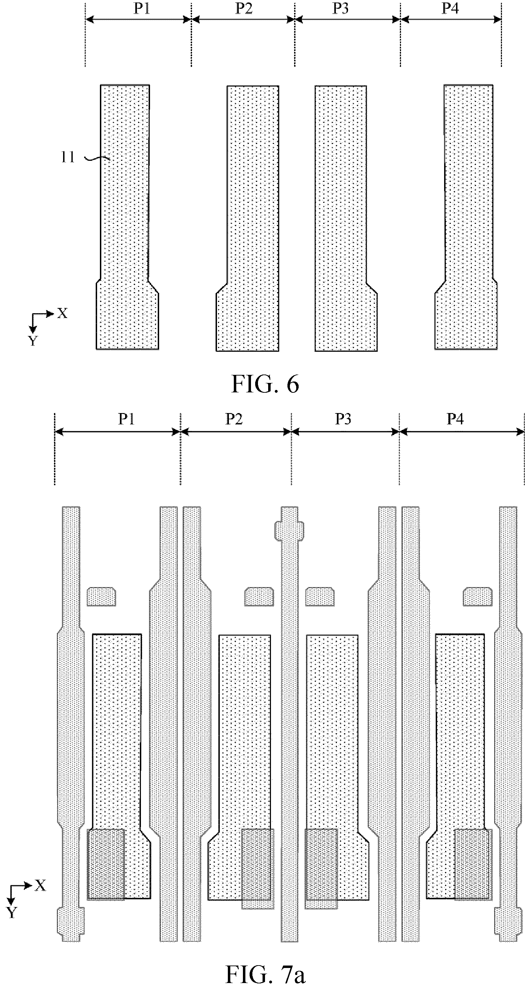

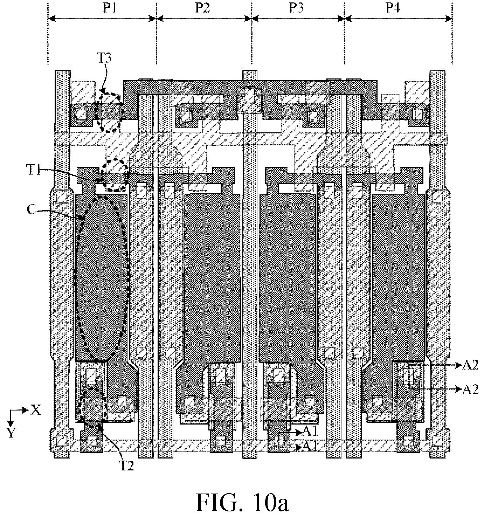

In an exemplary implementation mode, as shown in FIGS. 5a, 7a to 7b, and 10a to 10b, the display substrate may also include a shield metal layer, the gate metal layer is located on a side of the shield metal layer away from the base substrate in a direction perpendicular to the plane where the display substrate is located, and the plurality of data signal lines 25 may be located on the shield metal layer. As shown in FIGS. 7a to 7b and 10a to 10b, the plurality of auxiliary signal lines 45 and the plurality of data signal lines 25 may extend in the second direction Y and be arranged in the first direction X.

In an exemplary implementation mode, as shown in FIGS. 5a, 7a to 7b, and 10a to 10b, the shield metal layer may also be provided with a plurality of first power supply lines 21, and the gate metal layer may also be provided with a plurality of first power supply auxiliary lines 44, the plurality of first power supply lines 21 are electrically connected to the plurality of first power supply auxiliary lines 44, respectively, and orthographic projections of the plurality of first power supply lines 21 on the base substrate are at least partially overlapped with orthographic projections of the plurality of first power supply auxiliary lines 44 on the base substrate, respectively. In an embodiment of the present disclosure, the plurality of first power supply lines 21 are respectively electrically connected to the plurality of first power supply auxiliary lines 44 to form double-layer power supply traces, ensuring reliability of transmission of a power supply signal, and reducing a resistance of the first power supply lines 21, thereby reducing the RC on the first power supply lines.

In an exemplary implementation mode, as shown in FIGS. 5a, 7a to 7b, and 10a to 10b, the plurality of sub-pixels in the display substrate may form a plurality of pixel units arranged in an array, each pixel unit may include at least three sub-pixels (for example, each pixel unit may include four sub-pixels P1 to P4 arranged in the first direction X), the gate metal layer may also be provided with a plurality of first power supply connection lines 43, two first power supply auxiliary lines 44 are included in a same pixel unit, two ends of a first power supply connection line 43 located in a same pixel unit are respectively connected to the two first power supply auxiliary lines 44, on a plane parallel to the display substrate, a main body portion of the first power supply auxiliary line 44 extends in the second direction Y, a main body portion of a first power supply connection line 43 extends in the first direction X, the first direction X intersects the second direction Y.

In an exemplary implementation mode, a first power supply connection line 43 located in a same pixel unit may be integrally formed with two first power supply auxiliary lines 44. In an embodiment of the present disclosure, the plurality of first power supply lines 21 may extend in the second direction Y, and one first power supply line 21 may be electrically connected to a plurality of first power supply auxiliary lines 44 in a column of pixel units. Since the two first power supply auxiliary lines 44 located in a same pixel unit are electrically connected through the first power supply connection line 43, a grid-like structure can be formed on the display substrate as a whole by the first power supply lines 21 and the first power supply connection line 43, and the load on the first power supply lines can be reduced, so that a first power supply voltage provided to the plurality of sub-pixels in the display substrate are as consistent as possible, which is conducive to improving the uniformity of the panel, avoiding poor display of the display substrate, and ensuring the display effect of the display substrate.

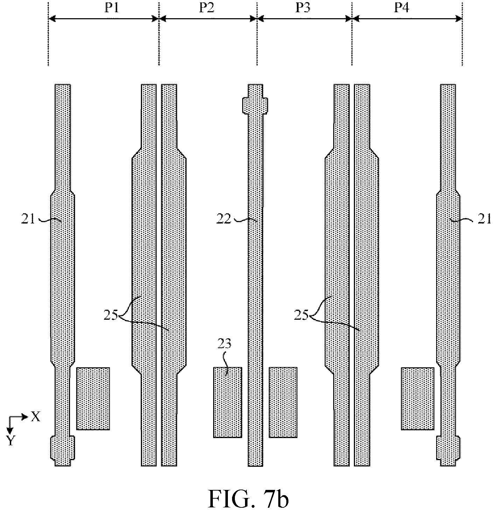

In an exemplary implementation mode, as shown in FIGS. 5a, 7a to 7b, and 8a to 8b, the display substrate may further include a semiconductor layer located on a side of the shield metal layer away from the base substrate in a direction perpendicular to the plane where the display substrate is located. The semiconductor layer is provided with a plurality of compensation connection lines 35, and the shield metal layer is further provided with a plurality of compensation signal lines 22. On a plane parallel to the display substrate, a compensation connection line 35 is in a structure of a strip extending in the first direction X, a compensation signal line 22 is in a structure of a strip extending in the second direction Y, the first direction X intersects with the second direction Y, and a compensation connection line 35 is electrically connected to at least one compensation signal line 22. As shown in FIGS. 7a and 7b, one pixel unit may include one compensation connection line 35, four sub-pixels in one pixel unit may be symmetrical with respect to the compensation signal line 22, that is, the first sub-pixel P1 and the fourth sub-pixel P4 located in a same pixel unit may be symmetrical with respect to the compensation signal line 22, and the second sub-pixel P2 and the third sub-pixel P3 may be symmetrical with respect to the compensation signal line 22. In an embodiment of the present disclosure, a same compensation signal line 22 can be electrically connected with a plurality of compensation signal lines 22 located in a same column of pixel units, and one compensation connection line 35 can be provided in a pixel unit to transmit a signal of the compensation signal line 22 to four sub-pixels in the pixel unit. Therefore, a mesh structure of the compensation signal lines can be formed by the plurality of compensation signal lines 22 and the plurality of compensation connection lines 35, and the load on the compensation signal lines 22 can be reduced, so that a compensation signal provided to the plurality of sub-pixels in the display substrate are as consistent as possible, which is beneficial to improving the uniformity of the panel, avoiding poor display of the display substrate, and ensuring the display effect of the display substrate.

In an exemplary implementation mode, in a structure shown in FIGS. 5a, 6 to 13b, in a direction perpendicular to the display substrate, the display substrate may include a base substrate and a first conductive layer, a second conductive layer (a shield metal layer), a first insulating layer, a semiconductor layer, a second insulating layer, a third conductive layer (a gate metal layer), a third insulating layer, a planarization layer, a fourth conductive layer, and a pixel definition layer sequentially disposed on the base substrate, wherein the second conductive layer may serve as the above-described shield metal layer and the third conductive layer may serve as the above-described gate metal layer. In an embodiment of the present disclosure, data signal lines are provided on the shield metal layer, which eliminates a source-drain metal layer, simplifies the process flow, and reduces the production cost of the display substrate.

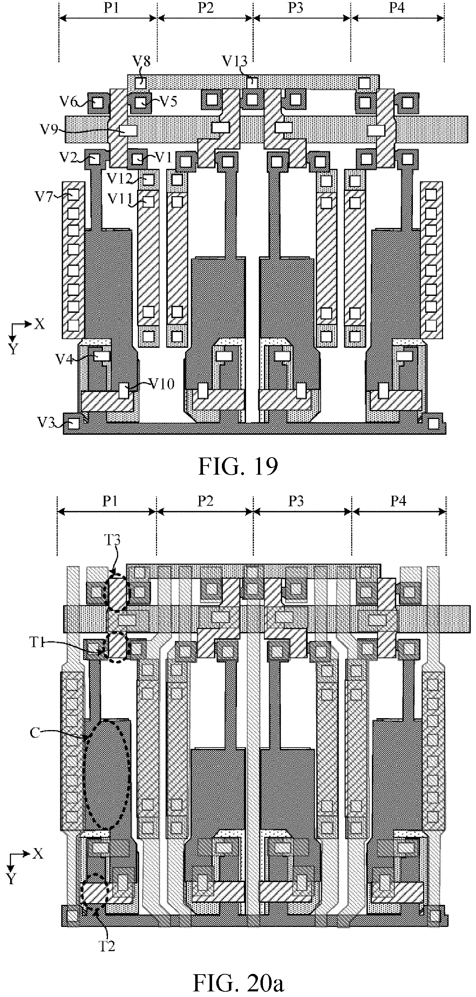

In an exemplary implementation mode, as shown in FIGS. 5b, 20a, and 20b, the display substrate may further include a source-drain metal layer which may be located on a side of the gate metal layer away from the base substrate in a direction perpendicular to the plane where the display substrate is located, and the plurality of data signal lines 25 may be located on the source-drain metal layer.

In an exemplary implementation mode, as shown in FIGS. 5b, 16a, 16b, 18a, 18b, 20a, and 20b, the display substrate may further include a second shield metal layer, the second shield metal layer may be located between the base substrate and the gate metal layer in a direction perpendicular to the plane where the display substrate is located, the plurality of auxiliary data lines 45 may include a plurality of first auxiliary data lines 451 and a plurality of second auxiliary data lines 452, the plurality of first auxiliary data lines 451 may be located in the second shield metal layer, the plurality of second auxiliary data lines 452 may be located in the gate metal layer, an orthographic projection of the plurality of first auxiliary data lines 451 and the plurality of second auxiliary data lines 452 on the base substrate and orthographic projections of a corresponding plurality of data signal lines 25 on the base substrate have overlapping regions, and the plurality of first auxiliary data lines 451 and the plurality of second auxiliary data lines 452 are electrically connected to the corresponding plurality of data signal lines 25.

In an exemplary implementation mode, as shown in FIGS. 5b, 18a, 18b, 20a, and 20b, the source-drain metal layer is further provided with a plurality of first power supply lines 21, and the gate metal layer is further provided with a plurality of first power supply auxiliary lines 44, the plurality of first power supply lines 21 are electrically connected to the plurality of first power supply auxiliary lines 44, respectively, and orthographic projections of the plurality of first power supply lines 21 on the base substrate are at least partially overlapped with orthographic projections of the plurality of first power supply auxiliary lines 44 on the base substrate, respectively. In an embodiment of the present disclosure, the plurality of first power supply lines 21 are respectively electrically connected to the plurality of first power supply auxiliary lines 44 to form double-layer power supply traces, ensuring reliability of transmission of a power supply signal, and reducing a resistance of the first power supply lines 21, thereby reducing the RC on the first power supply lines.

In an exemplary implementation mode, as shown in FIGS. 5b, 16a to 20b, the plurality of sub-pixels in the display substrate may form a plurality of pixel units arranged in an array, each pixel unit may include at least three sub-pixels (for example, each sub-pixel may include four sub-pixels arranged in the first direction X), the display substrate may also include a semiconductor layer, the semiconductor layer is located on a side of the second shield metal layer away from the base substrate in a direction perpendicular to the plane where the display substrate is located, the semiconductor layer is provided with a plurality of first power supply connection lines 43,two first power supply lines may be included in a same pixel unit, two ends of the first power supply connection line 43 located in a same pixel unit are electrically connected to the two first power supply lines 21, respectively, and on a plane parallel to the display substrate, a main body portion of a first power supply line 21 extends in the second direction Y, a main body portion of a first power supply connection line 43 extends in the first direction X, the first direction X intersects the second direction Y. In an embodiment of the present disclosure, the plurality of first power supply lines 21 may extend in the second direction Y, and one first power supply line 21 may be electrically connected to a plurality of first power supply auxiliary lines 44 in a column of pixel units. Since two first power supply lines 21 located in a same pixel unit are electrically connected through the first power supply connection line 43, a grid-like structure can be formed on the display substrate as a whole by the first power supply lines 21 and the first power supply connection lines 43, and the load on the first power supply lines are reduced, so that a first power supply voltage provided to the plurality of sub-pixels in the display substrate is as consistent as possible, which is conducive to improving the uniformity of the panel, avoiding poor display of the display substrate, and ensuring the display effect of the display substrate.

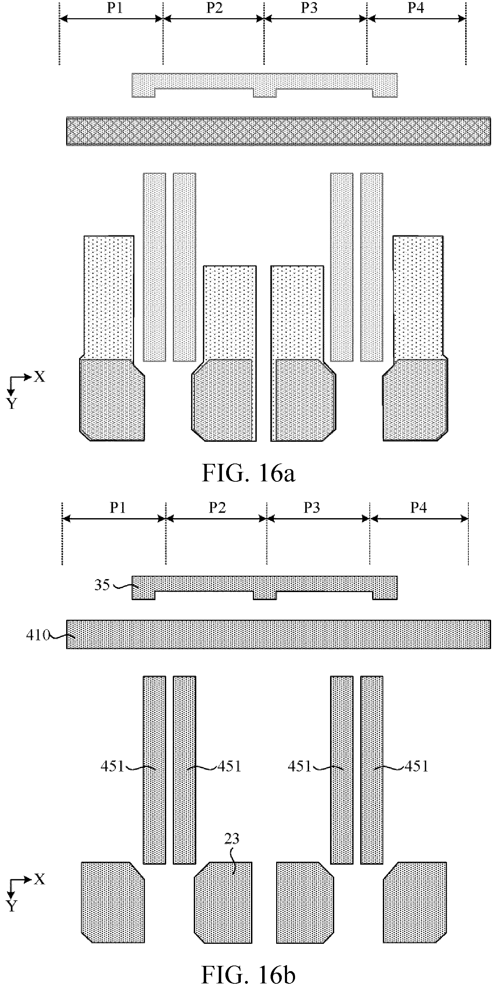

In an exemplary implementation mode, as shown in FIGS. 5b, 16a to 20b, the second shield metal layer may also be provided with a plurality of compensation connection lines 35, and the source-drain metal layer may also be provided with a plurality of compensation signal lines 22, on a plane parallel to the display substrate, a compensation connection line 35 is in a structure of a strip extending in the first direction X, a compensation signal line 22 is in a structure of a strip extending in the second direction Y, the first direction X intersects the second direction Y, and a compensation connection line 35 is electrically connected to at least one compensation signal line 22. As shown in FIGS. 16a to 20b, one pixel unit may include one compensation connection line 35, four sub-pixels in one pixel unit may be symmetrical with respect to the compensation signal line 22, that is, the first sub-pixel P1 and the fourth sub-pixel P4 located in a same pixel unit may be symmetrical with respect to the compensation signal line 22, and the second sub-pixel P2 and the third sub-pixel P3 may be symmetrical with respect to the compensation signal line 22. In an embodiment of the present disclosure, a same compensation signal line 22 can be electrically connected with a plurality of compensation signal lines 22 located in a same column of pixel units, and one compensation connection line 35 can be provided in a pixel unit to transmit a signal of the compensation signal line 22 to four sub-pixels in the pixel unit. Therefore, a mesh structure of the compensation signal lines can be formed by the plurality of compensation signal lines 22 and the plurality of compensation connection lines 35, and the load on the compensation signal lines 22 can be reduced, so that a compensation signal provided to the plurality of sub-pixels in the display substrate are as consistent as possible, which is beneficial to improving the uniformity of the panel, avoiding poor display of the display substrate, and ensuring the display effect of the display substrate.

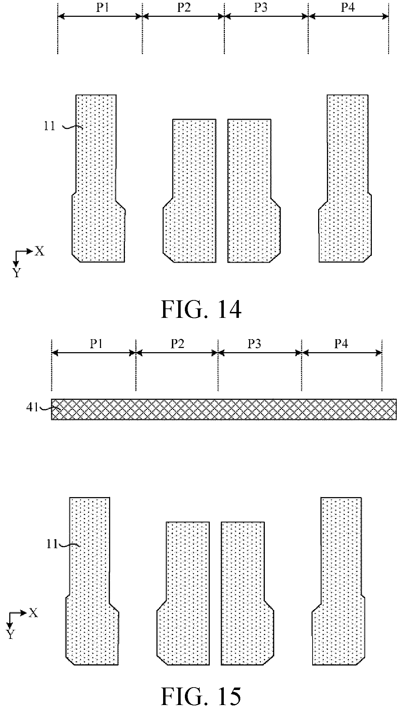

In an exemplary implementation mode, as shown in FIGS. 5b and 15, the display substrate may further include a first shield metal layer, which may be located between the base substrate and the second shield metal layer in a direction perpendicular to the plane where the display substrate is located. The first shield metal layer may be provided with a plurality of first scan signal lines 41, and the second shield metal layer may be provided with a plurality of first scan signal auxiliary lines 410 electrically connected to the plurality of first scan signal lines 41, respectively. Orthographic projections of the plurality of first scan signal lines 41 on the base substrate are at least partially overlapped with orthographic projections of the plurality of first scan signal auxiliary lines 410 on the base substrate, respectively. In an embodiment of the present disclosure, the plurality of first scan signal lines 41 are respectively electrically connected to the plurality of first scan signal auxiliary lines 410 to form double-layer power supply traces, ensuring the reliability of the first scan signal lines, and reducing a resistance of the first scan signal lines 41, thereby reducing the RC on the first power supply lines.

In an exemplary implementation mode, the orthographic projections of the plurality of first scan signal lines 41 on the base substrate cover the orthographic projections of the plurality of first scan signal auxiliary lines 410 on the base substrate, respectively, to prevent damage to the first scan signal auxiliary lines 410 in a subsequent etching process, and the first scan signal auxiliary lines 410 can protect the first scan signal lines 41.

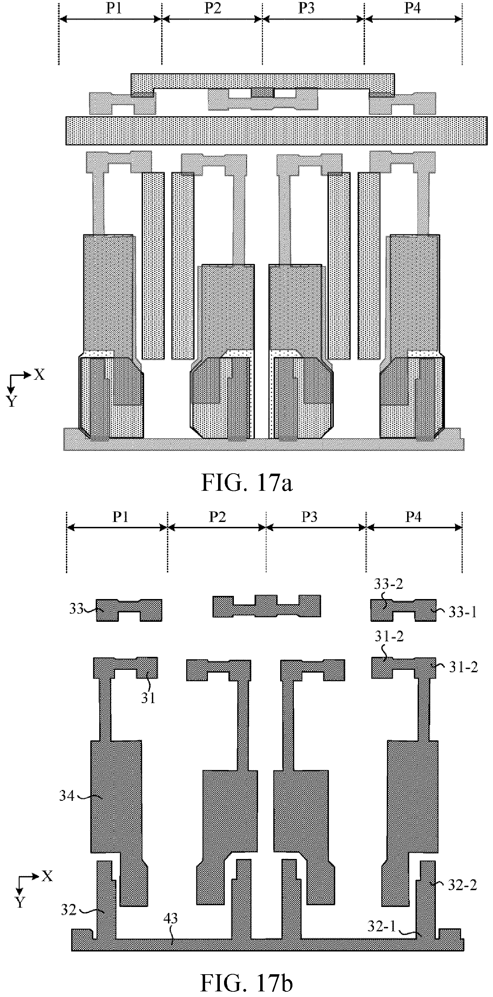

In an exemplary implementation mode, the thickness of the first shield metal layer is greater than the thickness of the second shield metal layer. That is, in a direction perpendicular to the plane where the display substrate is located, a size of a first scan signal line 41 is greater than a size of a first scan signal auxiliary line 410. On the one hand, the thickness of the first scan signal line 41 is thicker, which can reduce the impedance of the first scan signal line and reduce the RC. On the other hand, the relatively small thickness of the second shield metal layer can prevent the semiconductor layer from being cut off due to a thicker second shield metal layer in the region where the semiconductor layer partially overlaps with the second shield metal layer. As shown in FIG. 17b, the second shield metal layer may include a shield structure 23. An orthographic projection of the shield structure 23 on the base substrate and an orthographic projection of the pattern in the semiconductor layer (such as the second electrode plate 34 of the capacitor and the active layer 32 of the second transistor T2) on the base substrate have an overlapping region. If the thickness of the shield structure 23 is thicker, the second electrode plate 34 and the active layer 32 of the second transistor T2 are easily broken at edge portions overlapping with the shield structure 23, resulting in poor display substrate. The relatively thin thickness of the second shield metal layer can prevent the semiconductor layer from being cut off in a region where the semiconductor layer partially overlaps with the second shield metal layer.

In an exemplary implementation mode, in the structure shown in FIGS. 5b, 14 to 23b, the display substrate may include a base substrate and a first conductive layer, a second conductive layer (a first shield metal layer), a third conductive layer (a second shield metal layer), a first insulating layer, a semiconductor layer, a second insulating layer, a fourth conductive layer (a gate metal layer), a third insulating layer, a fifth conductive layer (a source-drain metal layer), a fourth insulating layer, a planarization layer, a sixth conductive layer, and a pixel definition layer disposed sequentially on the base substrate in a direction perpendicular to the display substrate, wherein the second conductive layer may serve as the first shield metal layer, the third conductive layer may serve as the second shield metal layer, and the fourth conductive layer may serve as the gate metal layer.

In an embodiment of the present disclosure, in the structure shown in FIGS. 5b, 14 to 23b, the first conductive layer is provided with first electrode plates of capacitors in the plurality of sub-pixels, the semiconductor layer is provided with second electrode plates of the capacitors in the plurality of sub-pixels, and the first scan signal lines 41 are provided in the shield metal layer instead of the gate metal layer, which, on the one hand, can reduce the capacitance of the data signal line 25 in the source-drain metal layer and the gate metal layer, thereby reducing RC, and on the other hand, can reduce the thickness of the first insulating layer, thereby increasing the capacitance value of the capacitor in a sub-pixel.

In an exemplary implementation mode, as shown in FIGS. 5a to 5c, each pixel unit may include four sub-pixels arranged in the first direction X, each sub-pixel may include a pixel drive circuit, and the pixel drive circuit of each sub-pixel may include a first transistor T1, a second transistor T2, a third transistor T3, and a capacitor C, in the second direction Y, the third transistor T3, the first transistor T1, the capacitor C, and the second transistor T2 are arranged sequentially in the second direction Y. In a same pixel unit, the second sub-pixel P2 and the third sub-pixel P3 may be arranged symmetrically with respect to the compensation signal line 22, and the first sub-pixel P1 and the fourth sub-pixel P4 may be arranged symmetrically with respect to the compensation signal line 22. In an embodiment of the present disclosure, a display region of the display substrate may include a plurality of sub-pixels arranged in an array, at least three sub-pixels may constitute a pixel unit, a plurality of pixel units and a plurality of sub-pixels may both be arranged in an array, and a plurality of signal lines 25 are electrically connected to a plurality of columns of sub-pixels respectively, and are configured to provide data signals to sub-pixels connected thereto; the compensation signal line 22 may be electrically connected to a plurality of columns of pixel units and configured to provide compensation signals to a plurality of sub-pixels in the pixel units electrically connected thereto; the first power supply line 21 may be electrically connected to a column of pixel units and is configured to provide a first power supply signal to a plurality of sub-pixels in the pixel units electrically connected thereto; the first scan signal line 41 may be electrically connected to a row of sub-pixels and is configured to provide a scan signal to the sub-pixels connected thereto.

An embodiment of the present disclosure also provides a preparation method for a display substrate, which may include: forming a plurality of sub-pixels and a plurality of transparent conductive layers 300 on a side of the base substrate, wherein at least a portion of the sub-pixels include at least a second transistor T2 and a third transistor T3, and a second electrode of the second transistor T2 and a second electrode of the third transistor T3 located in a same sub-pixel are connected by at least one transparent conductive layer 300.

In an exemplary implementation mode, the preparation method may also include forming a plurality of data signal lines 25 and a plurality of auxiliary data lines 45 on a side of the base substrate, wherein the plurality of data signal lines 25 are electrically connected to the plurality of auxiliary data lines 45, respectively, the data signal lines 25 and the auxiliary data lines 45 are located on different conductive layers, the conductive layers in which the data signal lines 25 and the auxiliary data lines 45 are located are located between the base substrate and the transparent conductive layer 300 in a direction perpendicular to the plane where the display substrate is located, and orthographic projections of the plurality of data signal lines 25 on the base substrate are at least partially overlapped with orthographic projections of the plurality of auxiliary data lines 45 on the base substrate, respectively.

In an exemplary implementation mode, forming a plurality of auxiliary data lines 45 on the base substrate may include forming a gate metal layer on a side of the base substrate, at least a portion of the auxiliary data lines 45 are located on the gate metal layer.

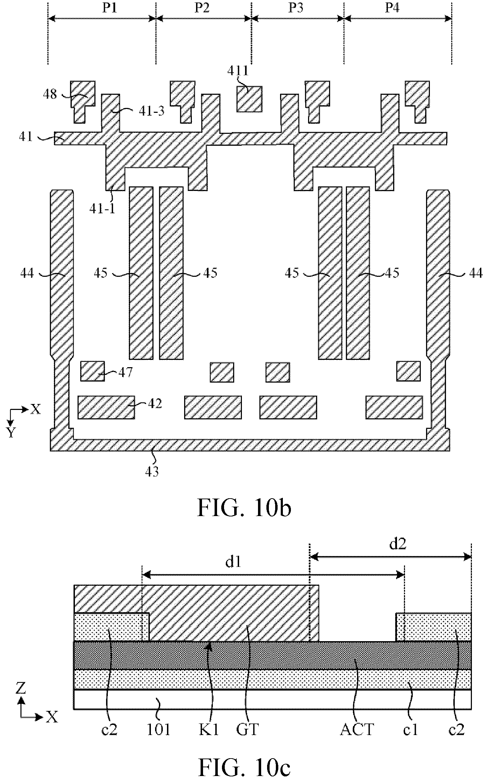

In an exemplary implementation mode, as shown in FIGS. 10c and 10d, FIG. 10c is a schematic diagram of a cross-section structure at a position A1-A1 in FIG. 10a, and FIG. 10d is a schematic diagram of a cross-section structure at a position A2-A2 in FIG. 10a, before the gate metal layer is formed on a side of the base substrate, it may further include forming a shield metal layer SHL on a side of the base substrate 101 close to the gate metal layer GT, the gate metal layer GT is located on a side of the shield metal layer SHL away from the base substrate 101 in a direction perpendicular to the plane where the display substrate is located, and the plurality of data signal lines 25 are located on the shield metal layer SHL.

In an exemplary implementation mode, as shown in FIGS. 5a, 7a to 7b, and 10a to 10c, the shield metal layer may also be provided with a plurality of first power supply lines 21, and the gate metal layer may also be provided with a plurality of first power supply auxiliary lines 44, the plurality of first power supply lines 21 are electrically connected to the plurality of first power supply auxiliary lines 44, respectively, and orthographic projections of the plurality of first power supply lines 21 on the base substrate are at least partially overlapped with orthographic projections of the plurality of first power supply auxiliary lines 44 on the base substrate, respectively. In an embodiment of the present disclosure, the plurality of first power supply lines 21 are respectively electrically connected to the plurality of first power supply auxiliary lines 44 to form double-layer power supply traces, ensuring reliability of transmission of a power supply signal, and reducing a resistance of the first power supply lines 21, thereby reducing the RC on the first power supply lines.

In an exemplary implementation mode, as shown in FIGS. 5a, 7a to 7b, and 10a to 10b, the display substrate may further include a plurality of pixel units which are arranged in an array and provided are on the base substrate, each pixel unit may include four sub-pixels P1 to P4 arranged in the first direction X, the gate metal layer may further be provided with a plurality of first power supply connection lines 43, a same pixel unit includes two first power supply auxiliary lines 44, two ends of a first power supply connection line 43 located in a same pixel unit are respectively connected to the two first power supply auxiliary lines 44, on a plane parallel to the display substrate, a main body portion of a first power supply auxiliary line 44 extends in the second direction Y, a main body portion of a first power supply connection line 43 extends in the first direction X, the first direction X intersects the second direction Y.

In an exemplary implementation mode, after the shield metal layer SHL is formed on a side of the base substrate 101 and before the gate metal layer GT is formed on a side of the base substrate 101, it may further include forming a semiconductor layer ACT on a side of the shield metal layer SHL away from the base substrate 101. The semiconductor layer ACT is provided with a plurality of compensation connection lines 35, and the shield metal layer SHL is further provided with a plurality of compensation signal lines 22. On a plane parallel to the display substrate, a compensation connection line 35 may be in a structure of a strip extending in the first direction X, a compensation signal line 22 may be in a structure of a strip extending in the second direction Y, the first direction X intersects the second direction Y, and a compensation connection line 35 is electrically connected to at least one compensation signal line 22.

In an exemplary implementation mode, as shown in FIG. 10c, forming the gate metal layer GT on a side of the base substrate 101 may include:
Forming a second insulating thin film on a side of the semiconductor layer ACT away from the base substrate 101;
Patterning the second insulating thin film using a patterning process to form a second insulating layer c2 including a pattern of a second insulating layer, the pattern of the second insulating layer c2 may include a plurality of first connection vias K1, the plurality of first connection vias K1 exposing a surface of the semiconductor layer ACT;
Performing a conductorization treatment on the semiconductor layer exposed by the first connection vias K1 to form a plurality of first conductorized regions d1, and orthographic projections of the plurality of first conductorized regions d1 on the base substrate 101 cover orthographic projections of the plurality of first connection vias K1 on the base substrate 101, respectively;
Forming a gate metal layer GT on a side of the second insulating layer c2 away from the base substrate 101.

In an exemplary implementation mode, as shown in FIG. 10d, forming the semiconductor layer ACT on a side of the shield metal layer SHL away from the base substrate 101 may include:
Forming a first insulating layer c1 on a side of the shield metal layer SHL away from the base substrate 101;
Forming a semiconductor layer ACT on a side of the first insulating layer c1 away from the base substrate 101;
The process of patterning the second insulating thin film using a patterning process to form a second insulating layer c2 including a pattern of a second insulating layer may further include: patterning the first insulating thin film to form a plurality of second connection vias K2 that expose a surface of the shield metal layer SHL and a surface of the semiconductor layer ACT;
The process of performing a conductorization treatment on the semiconductor layer exposed by the first connection vias K1 to form a plurality of first conductorized regions may further include performing a conductorization treatment on the semiconductor layer ACT exposed by the second connection vias K2 to form a plurality of second conductorized regions d2, and orthographic projections of the plurality of second conductorized regions d2 on the base substrate 101 cover orthographic projections of the semiconductor layer ACT exposed by the plurality of second connection vias K2 on the base substrate 101, respectively.

In an exemplary implementation mode, after the gate metal layer GT is formed on a side of the second insulating layer c2 away from the base substrate, it may also include:
Removing the second insulating c2 film outside the coverage region of the gate metal layer GT to expose a region to be conductorized in the semiconductor layer ACT;
Performing a conductorization treatment on a region to be conductorized in the semiconductor layer to form a third conductorized region, and an orthographic projection of the plurality of first conductorized regions d1 and the plurality of second conductorized regions d2 on the base substrate overlap at least partially with an orthographic projection of the third conductorized region on the base substrate.

In an embodiment of the present disclosure, the third conductorized region may be the semiconductor layer ACT not covered by the gate metal layer GT, and orthographic projections of the plurality of first conductorized regions d1 and the plurality of second conductorized regions d2 on the base substrate overlaps at least partially with an orthographic projection of the third conductorized region on the base substrate, so that the first conductorized regions d1 located in the plurality of first connection vias K1 and the second conductorized regions d2 located in the plurality of second connection vias K2 can be electrically connected with the third conductorized region (that is, the first conductorized regions d1 and the second conductorized regions d2 can be lapped with the third conductorized region), and the existence of unconductorized regions in the first conductorized regions d1 and the second conductorized regions d2 and the third conductorized region can be avoided.

In an embodiment of the present disclosure, orthographic projections of the plurality of second conductorized regions d2 on the base substrate 101 cover orthographic projections of the semiconductor layer ACT exposed by the plurality of second connection vias K2 on the base substrate 101, respectively, so that the plurality of second conductorized regions d2 and the third conductorized region can be electrically connected, and the existence of unconductorized regions in the first conductorized regions d1 and the second conductorized regions d2 and the third conductorized region can be avoided. Orthographic projections of the plurality of first conductorized regions d1 on the base substrate 101 cover orthographic projections of the plurality of first connection vias K1 on the base substrate 101, respectively, so that the first conductorized regions d1 located in the plurality of first connection vias K1 can be electrically connected with the third conductorized region (that is, the first conductorized regions d1 can be lapped with the third conductorized region), and the existence of unconductorized regions in the first conductorized region d1 and the third conductorized region can be avoided.

In an exemplary implementation mode, as shown in FIGS. 10c and 10d, an orthographic projection of the second conductorized region d2 on the base substrate is at least partially overlapped with an orthographic projection of at least a portion of the gate metal layer GT on the base substrate, so that the second conductorized region d2 can be electrically connected to the gate metal layer GT, and the reliability of the electrical connection of the second conductorized region d2 to the pattern of the gate metal layer GT is improved.

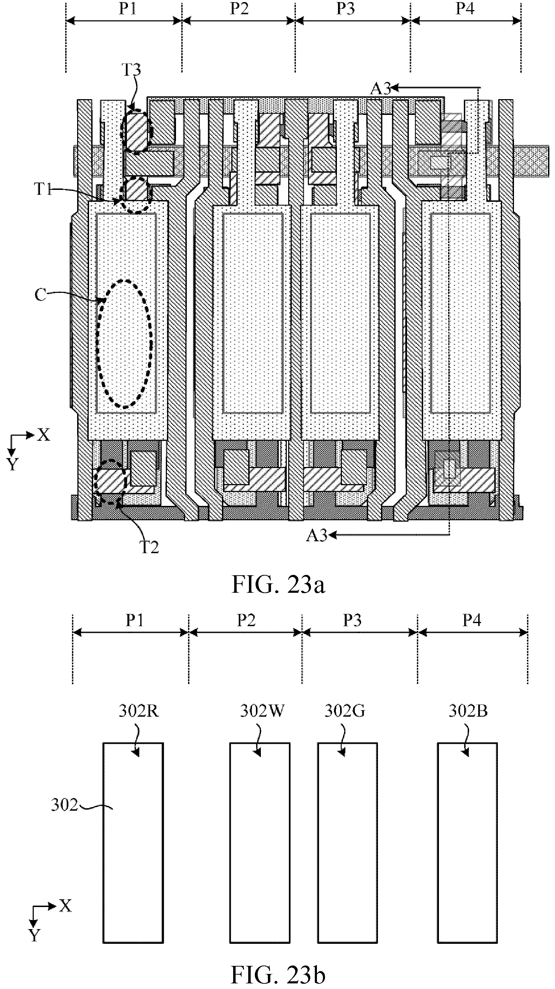

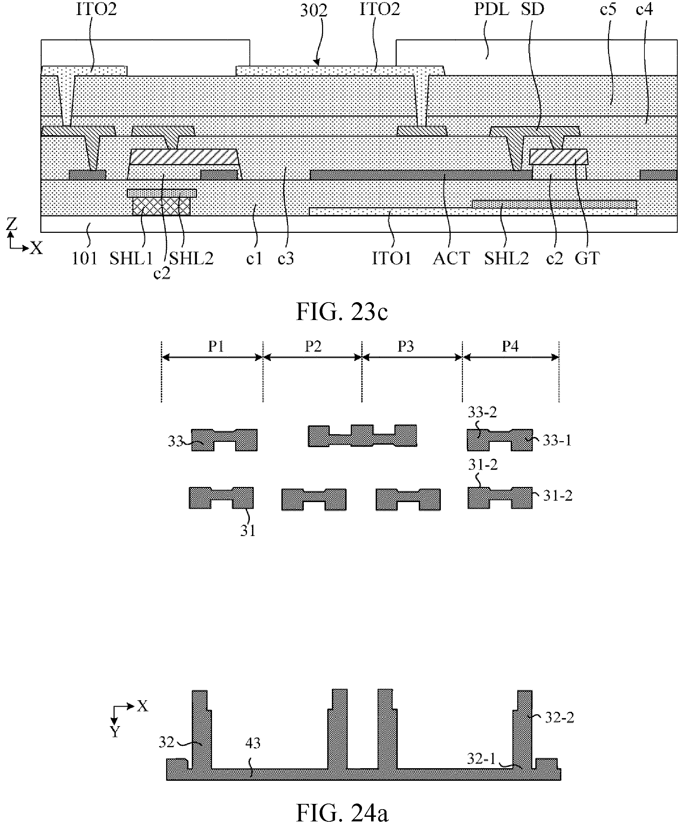

In an exemplary implementation mode, as shown in FIG. 23c, FIG. 23c is a schematic diagram of a cross-section structure at a position A3-A3 in FIG. 23a, after the gate metal layer GT is formed on a side of the base substrate 101, it may also include forming a source-drain metal layer SD on a side of the gate metal layer GT away from the base substrate 101, and the plurality of data signal lines 25 are located in the source-drain metal layer SD.

In an exemplary implementation mode, before forming the gate metal layer GT on a side of the base substrate 101, it may also include: forming a second shield metal layer SHL2 on a side of the base substrate 101 close to the gate metal layer GT, the plurality of auxiliary data lines 45 include a plurality of first auxiliary data lines 451 and a plurality of second auxiliary data lines 452, the plurality of first auxiliary data lines 451 are located on the second shield metal layer SHL2, the plurality of second auxiliary data lines 452 are located on the gate metal layer GT, orthographic projections of the plurality of first auxiliary data lines 451 and the plurality of second auxiliary data lines 452 on the base substrate 101 and orthographic projections of a corresponding plurality of data signal lines 25 on the base substrate 101 have overlapping regions, and the plurality of first auxiliary data lines 451 and the plurality of second auxiliary data lines 452 are electrically connected to the corresponding plurality of data signal lines 25.

In an exemplary implementation mode, as shown in FIGS. 5b, 18a, 18b, 20a, 20b, and 23c, the source-drain metal layer is further provided with a plurality of first power supply lines 21, and the gate metal layer is further provided with a plurality of first power supply auxiliary lines 44, the plurality of first power supply lines 21 are electrically connected to the plurality of first power supply auxiliary lines 44, respectively, and orthographic projections of the plurality of first power supply lines 21 on the base substrate are at least partially overlapped with orthographic projections of the plurality of first power supply auxiliary lines 44 on the base substrate, respectively. In an embodiment of the present disclosure, the plurality of first power supply lines 21 are respectively electrically connected to the plurality of first power supply auxiliary lines 44 to form double-layer power supply traces, ensuring reliability of transmission of a power supply signal, and reducing a resistance of the first power supply lines 21, thereby reducing the RC on the first power supply lines.

In an exemplary implementation mode, as shown in FIGS. 5b, 16a, 20b, and 23c, the display substrate may include a plurality of pixel units arranged in an array and provided on the base substrate, each pixel unit may include four sub-pixels arranged in the first direction X, the display substrate may also include a semiconductor layer, the semiconductor layer is located on a side of the second shield metal layer away from the base substrate in a direction perpendicular to the plane where the display substrate is located, the semiconductor layer is provided with a plurality of first power supply connection lines 43, two first power supply lines may be included in a same pixel unit, two ends of the first power supply connection line 43 located in a same pixel unit are respectively electrically connected to the two first power supply lines 21, and on a plane parallel to the display substrate, a main body portion of a first power supply line 21 extends in the second direction Y, a main body portion of a first power supply connection line 43 extends in the first direction X, the first direction X intersects the second direction Y.

In an exemplary implementation mode, as shown in FIGS. 5b, 16a to 20b, and 23c, the second shield metal layer may also be provided with a plurality of compensation connection lines 35, and the source-drain metal layer may also be provided with a plurality of compensation signal lines 22, on a plane parallel to the display substrate, a compensation connection line 35 is in a structure of a strip extending in the first direction X, a compensation signal line 22 is in a structure of a strip extending in the second direction Y, the first direction X intersects the second direction Y, and a compensation connection line 35 is electrically connected to at least one compensation signal line 22.

In an exemplary implementation mode, before the second shield metal layer SHL2 is formed on a side of the base substrate 101 close to the gate metal layer GT, it may also include forming a first shield metal layer SHL1 on a side of the base substrate 101 close to the second shield metal layer SHL2, the first shield metal layer SHL1 is located between the base substrate 101 and the second shield metal layer SHL2 in a direction perpendicular to the plane where the display substrate is located, the first shield metal layer SHL1 is provided with a plurality of first scan signal lines 41, the second shield metal layer SHL2 is provided with a plurality of first scan signal auxiliary lines 410 electrically connected to the plurality of first scan signal lines 41, respectively, and orthographic projections of the plurality of first scan signal lines 41 on the base substrate 101 are at least partially overlapped with orthographic projections of the plurality of first scan signal auxiliary lines 410 on the base substrate 101, respectively.

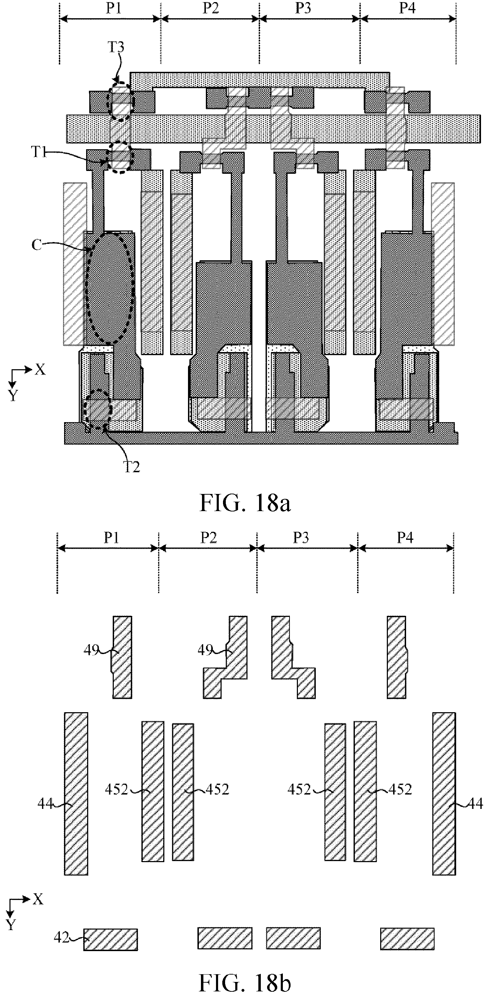

In an embodiment of the present disclosure, as shown in FIG. 23c, c1 to c5 are a first insulating layer to a fifth insulating layer, ITO1 is a first conductive layer, ITO2 is a sixth conductive layer, the first conductive layer ITO1 and the sixth conductive layer ITO2 may be conductive glass, and SD is a source-drain metal layer. A schematic diagram of a planar structure of the first conductive layer ITO1 can be referred to FIG. 14,a schematic diagram of a planar structure of the first shield layer SHL1 can be referred to FIG. 15,a schematic diagram of a planar structure of the second shield layer SHL2 can be referred to FIG. 16b,a schematic diagram of a planar structure of the semiconductor layer ACT can be referred to FIG. 17b,a schematic diagram of a planar structure of the gate metal layer GT can be referred to FIG. 18b,schematic diagrams of planar structures of the second insulating layer c2 and the third insulating layer c3 can be referred to FIG. 19,a schematic diagram of a planar structure of the source-drain metal layer SD can be referred to FIG. 20b,schematic diagrams of planar structures of the fourth insulating layer c4 and the planarization layer c5 can be referred to FIG. 21,a schematic diagram of a planar structure of the sixth conductive layer ITO2 can be referred to FIG. 22b,a schematic diagram of a planar structure of the pixel definition layer PDL can be referred to FIG. 23b.

In an embodiment of the present disclosure, as shown in FIGS. 23c and 21, orthographic projections of vias on the fourth insulating layer c4 on the base substrate and orthographic projections of vias on the planarization layer c5 on the base substrate overlap, and the vias on the fourth insulating layer c4 and the planarization layer c5 can be formed by a single patterning process, eliminating the need for two preparation processes, simplifying the preparation process, and reducing the preparation cost of display substrate..

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation mode, taking four sub-pixels (first sub-pixel P1, second sub-pixel P2, third sub-pixel P3, and fourth sub-pixel P4) as an example, the preparation process of the drive circuit layer may include the following operations.

(11) A pattern of a first conductive layer is formed. In an exemplary implementation mode, forming a pattern of a first conductive layer may include depositing a first conductive thin film on a base substrate, patterning the first conductive thin film by a patterning process to form a pattern of a first conductive layer on the base substrate, and the pattern of the first conductive layer includes at least a first electrode plate 11 formed in each sub-pixel, as shown in FIG. 6. In an exemplary embodiment, a first conductive layer may be referred to as a first transparent (ITO1) layer.

In an exemplary implementation mode, the first electrode plate 11 in each sub-pixel is configured to form a transparent electrode plate of the storage capacitor, the first electrode plate 11 may be in a shape of a rectangle, and edges of the rectangle may be of a polyline.

(12) A pattern of a second conductive layer is formed. In an exemplary implementation mode, forming a pattern of a second conductive layer may include depositing a second conductive thin film on the base substrate on which the above-mentioned patterns are formed, patterning the second conductive thin film by a patterning process to form a pattern of a second conductive layer on the first conductive layer, the pattern of the second conductive layer including at least a first power supply line 21, a compensation signal line 22, and a shield structure 23 and a data signal line 25 formed in each sub-pixel, as shown in FIGS. 7a and 7b, where FIG. 7b is a schematic plan view of the second conductive layer in FIG. 7a. In an exemplary embodiment, the second conductive layer may be referred to as a shield metal (SHL) layer.

In an exemplary implementation mode, the two first power supply lines 21 may be in a structure of a strip extending in the second direction Y and sequentially disposed in the first direction X. In a pixel unit, the first electrode plates 11 in the plurality of sub-pixels may be located between the two first power supply connection lines 21 in the first direction X, the two first power supply lines 21 are configured to be electrically connected to the first power supply connection lines formed subsequently, respectively, and to provide power supply voltages to the second transistors T2 in the first sub-pixel P1 to the fourth sub-pixel P4, respectively.

In an exemplary implementation mode, the compensation signal line 22 may be in a structure of a strip extending in the second direction Y. The compensation signal line 22 is located between the two first power supply connection lines 21, and in the first direction X, the two first power supply connection lines 21 may be symmetrical with respect to the compensation signal line 22, and the second sub-pixel P2 and the third sub-pixel P3 may be symmetrical with respect to the compensation signal line 22. The compensation signal lines 22 are configured to be connected to the compensation signal line formed subsequently, respectively, and provide compensation voltages to the third transistors T3 of the first sub-pixel P1 to the fourth sub-pixel P3.

In an exemplary implementation mode, a shield structure 23 may be provided in each sub-pixel, an orthographic projection of the shield structure 23 on the base substrate overlaps at least partially with an orthographic projection of the first electrode plate 11 on the base substrate, and the shield structure 23 is electrically connected to the first electrode plate 11.

In the exemplary embodiment, data signal lines 25 are respectively provided at each sub-pixel and a main body portion of the data signal lines 25 extends along the second direction Y. The data signal line 25 may be connected to a first region 31-1 of an active layer of the first transistor formed subsequently through a via to enable writing of a data signal to the first transistor T1.

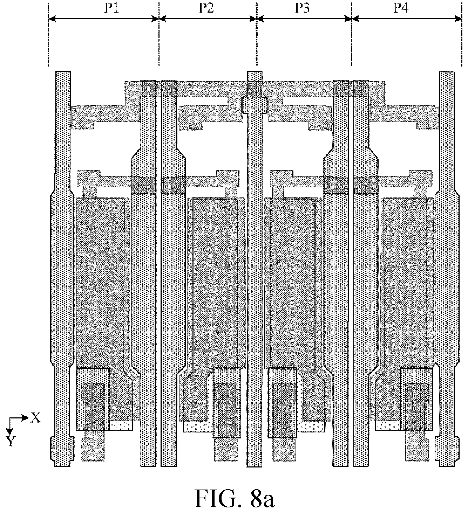

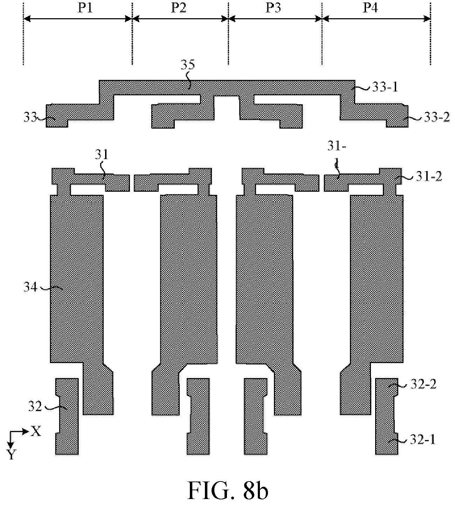

(13) A pattern of a semiconductor layer is formed. In an exemplary embodiment, forming a pattern of a semiconductor layer may include sequentially depositing a first insulating thin film and a semiconductor thin film on the base substrate on which the above-mentioned patterns are formed, patterning the semiconductor thin film by a patterning process to form a first insulating layer covering the second conductive layer, and a pattern of a semiconductor layer disposed on the first insulating layer, the pattern of the semiconductor layer including at least an active layer 31 of the first transistor T1, an active layer 32 of the second transistor T2, an active layer 33 of the third transistor T3, a second electrode plate 34, and a compensation connection line 35 formed in each sub-pixel, as shown in FIGS. 8a and 8b, where FIG. 8b is a schematic plan view of the semiconductor layer in FIG. 8a.

In an exemplary embodiment, there is an overlapping region between an orthographic projection of the second electrode plate 34 on the base substrate and an orthographic projection of the first electrode plate 11 on the base substrate in each sub-pixel, the second electrode plate 34 is configured as another transparent electrode plate that forms a storage capacitor, and the first electrode plate 11 and the second electrode plate 34 form a transparent storage capacitor.

In an exemplary implementation mode, the second electrode plate 34 may be in a shape of a rectangle, and edges of the rectangle may be of a polyline.

In an exemplary implementation mode, in each sub-pixel, the shape of the second electrode plate 34 may be similar to the shape of the first electrode plate 11 in the sub-pixel where the second electrode plate 34 is located, and an orthographic projection of the second electrode plate 34 on the base substrate may cover an orthographic projection of the first electrode plate 11 on the base substrate.

In an exemplary implementation mode, the active layer 31 of the first transistor T1, the active layer 32 of the second transistor T2, and the active layer 33 of the third transistor T3 each include a channel region and first and second regions located at two sides of the channel region.

In an exemplary implementation mode, the active layer 31 of the first transistor T1 may be "L"-shaped, and the active layer 31 of the first transistor T1 may be located on a side of the second electrode plate 34 in the second direction Y. In the first direction X, the first region 31-1 of the active layer 31 of the first transistor T1 is located on a side of the channel region away from the second electrode plate 34, and the second region 31-2 of the active layer 31 of the first transistor T1 is located on a side of the channel region close to the second electrode plate 34. In each sub-pixel, an orthographic projection of the first region 31-1 of the active layer 31 of the first transistor T1 on the base substrate is at least partially overlapped with an orthographic projection of the data signal line 25 on the base substrate.

In an exemplary implementation mode, the second region 31-2 of the active layer 31 of the first transistor T1 may be connected to the second electrode plate 34, and the active layer 31 of the first transistor T1 and the second electrode plate 34 are of an interconnected integrally formed structure.

In an exemplary implementation mode, the first region 31-1 of the active layer 31 of the first transistor T1 is in a structure of a strip extending in the first direction X, and the structure of a strip extends from the second region 31-2 of the active layer 31 of the first transistor T1 towards an adjacent sub-pixel. The structure of a strip in the first sub-pixel P1 extends towards the second sub-pixel P2, and the structure of a strip in the third sub-pixel P3 extends towards the fourth sub-pixel P4; the structure of a strip in the second sub-pixel P2 extends towards the first sub-pixel P1, and the structure of a strip in the fourth sub-pixel P3 extends towards the third sub-pixel P3. Since the second region 31-2 of the active layer 31 of the first transistor T1 is electrically connected to a gate electrode of the second transistor T2 through a second electrode of the first transistor T1 formed subsequently, the interconnection between the second electrode of the first transistor T1, the gate electrode of the second transistor T2, and the second electrode plate of the storage capacitor is realized.

In an exemplary implementation mode, the active layer 32 of the second transistor T2 may be "I"-shaped, and in the second direction Y, the second active layer 32 may be located at a side of the second electrode plate 34 away from the active layer 31 of the first transistor T1. An orthographic projection of the active layer 32 of the second transistor T2 on the base substrate is spaced apart from an orthographic projection of the second electrode plate 34 on the base substrate, that is, there is no overlapping region between the second active layer 32 and the second electrode plate 34, which is conducive to designing the width-length ratio of the channel of the second transistor according to the relevant requirements. The first region 32-1 of the active layer 32 of the second transistor T2 is located on a side of the channel region away from the second electrode plate 34, and there is an overlapping region between an orthographic projection of a portion of the first region 32-1 of the active layer 32 of the second transistor T2 on a side close to the channel region on the base substrate and an orthographic projection of the shield structure 23 on the base substrate. The second region 32-2 of the active layer 32 of the second transistor T2 is located on a side of the channel region close to the second electrode plate 34, and there is an overlapping region between an orthographic projection of the second region 32-2 of the active layer 32 of the second transistor T2 on the base substrate and an orthographic projection of the shield structure 23 on the base substrate. In this way, the shield structure 23 can shield the channel region of the second active layer 32 to avoid the influence of light on the channel and reduce the leakage current, thereby avoiding the influence of light on the transistor characteristics.

In an exemplary implementation mode, the active layer 33 of the third transistor T3 may be in a structure of an "L"-shaped polyline, and in the second direction Y, the active layer 33 of the third transistor T3 may be located on a side of the active layer 31 of the first transistor T1 away from the second electrode plate 34. An orthographic projection of the active layer 33 of the third transistor T3 on the base substrate is spaced apart from an orthographic projection of the second electrode plate 34 on the base substrate, that is, there is no overlapping region between the third active layer 33 and the second electrode plate 42, which is conducive to designing the width-length ratio of the channel of the third transistor according to the relevant requirements. The first region 33-1 of the active layer 33 of the third transistor T3 is located on a side of the channel region away from the second electrode plate 34, and the first region 33-1 of the active layer 33 of the third transistor T3 and the compensation connection line 35 may be of an interconnected integral structure.

In an exemplary implementation mode, the compensation connection line 35 may be in a structure of a strip extending in the first direction X, and in the second direction Y, the compensation connection line 35 is located on a side of an active layer of the third transistor T3 away from the second electrode plate 34, and there is an overlapping region between an orthographic projection of the compensation connection line 35 on the base substrate and an orthographic projection of the compensation signal line 22 on the base substrate. The compensation connection line 35 may be connected to the first region 33-1 of the active layer 33 of the third transistor T3, and is of an integrally formed structure with the active layer 33 of the third transistor T3.

In an exemplary implementation mode, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or multiple layers.

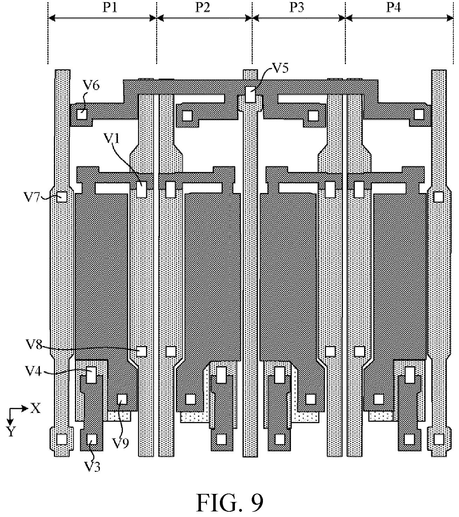

(14) A pattern of a second insulation layer is formed. In an exemplary embodiment, forming a pattern of a second insulating layer may include: depositing a second insulating thin film on the base substrate on which the above-mentioned patterns are formed, patterning the second insulating thin film using a patterning process to form a second insulating layer covering the semiconductor layer, a plurality of vias are provided on the second insulating layer, the plurality of vias include at least a first via V1, a third via V3, a fourth via V4, a fifth via V5, a sixth via V6, a seventh via V7, an eighth via V8, and a ninth via V9, as shown in FIG. 9.

In an exemplary embodiment, a first via V1 may be provided in each sub-pixel, an orthographic projection of the first via V1 on the base substrate at least partially overlaps, on the one hand, an orthographic projection of the first region 31-1 of the active layer 31 of the first transistor T1 on the base substrate, and on the other hand, an orthographic projection of the data signal line 25 on the base substrate, the second insulating layer and the first insulating layer within the first via V1 are etched off to expose a surface of the first region 31-1 of the active layer 31 of the first transistor T1 and a surface of the data signal line 25 simultaneously. The first via V1 is a transfer via, and the transfer via is composed of two half-holes, one half-hole is formed on the first region 31-1 of the active layer 31 of the first transistor T1, and the other half-hole is formed on the data signal line 25, so that the transfer via formed of the two half-holes exposes a surface of the first region 31-1 of the active layer 31 of the first transistor T1 and a surface of the data signal line 25 simultaneously. In an exemplary embodiment, the first via V1 is configured such that a first electrode of the active layer 31 of the first transistor T1 formed subsequently is connected to the data signal line 25 and the active layer 31 of the first transistor T1 through the via simultaneously.

**In** an exemplary embodiment, a third via V3 may be provided in each sub-pixel, an orthographic projection of the third via V3 on the base substrate is within a range of an orthographic projection of the first region 32-1 of the active layer 32 of the second transistor T2 on the base substrate, and the second insulating layer within the third via V3 is etched off to expose a surface of the first region 32-1 of the active layer 32 of the second transistor T2. **In an** exemplary embodiment, the third via V3 is configured such that a first power supply connection line formed subsequently is connected with the active layer 32 of the second transistor T2 through the via.

**In** an exemplary embodiment, a fourth via V4 may be provided in each sub-pixel, an orthographic projection of the fourth via V4 on the base substrate at least partially overlaps, on the one hand, an orthographic projection of the second region 32-2 of the active layer 32 of the second transistor T2 on the base substrate, and on the other hand, an orthographic projection of the shield structure 23 on the base substrate, the second insulating layer and the first insulating layer within the fourth via V4 are etched off to expose a surface of the second region 32-2 of the active layer 32 of the second transistor T2 and a surface of the shield structure 23 simultaneously. In an exemplary embodiment, the fourth via V4 is configured such that a second electrode of the subsequently formed second transistor T2 is simultaneously connected to the shield structure 23 and the active layer 32 of the second transistor T2 through the via.

In an exemplary embodiment, a fifth via V5 may be disposed between the second sub-pixel P2 and the third sub-pixel P3, an orthographic projection of the fifth via V5 on the base substrate at least partially overlaps an orthographic projection of the compensation connection line 35 on the base substrate on the one hand, and an orthographic projection of the compensation signal line 22 on the base substrate on the other hand, and the second insulating layer and the first insulating layer within the fifth via V5 are etched off to expose a surface of the compensation connection line 35 and a surface of the compensation signal line 22 simultaneously. In an exemplary embodiment, the fifth via V5 is configured so that a first electrode of the subsequently formed third transistor T3 is simultaneously connected to the compensation signal line 22 and the compensation connection line 35 through the via.

In an exemplary embodiment, a sixth via V6 may be provided in each sub-pixel, an orthographic projection of the sixth via V6 on the base substrate is within a range of an orthographic projection of the second region 33-2 of the active layer 33 of the third transistor T3 on the base substrate, and the second insulating layer within the sixth via V6 is etched off to expose a surface of the second region 33-2 of the active layer 33 of the third transistor T3. In an exemplary embodiment, the sixth via V6 is configured such that a second electrode of the subsequently formed third transistor T3 is connected with the active layer 33 of the third transistor T3 through the via.

In an exemplary embodiment, a seventh via V7 may be provided in the first sub-pixel P1 and the fourth sub-pixel P4, an orthographic projection of the seventh via V7 on the base substrate is within a range of an orthographic projection of the first power supply line 21 on the base substrate, and the second insulating layer within the seventh via V7 is etched off to expose a surface of the first power supply line 21. In an exemplary embodiment, the seventh via V7 is configured such that a first power supply auxiliary line formed subsequently is connected with the first power supply line 21 through the via.

In an exemplary embodiment, an eighth via V8 may be provided in each sub-pixel, an orthographic projection of the eighth via V8 on the base substrate is within a range of an orthographic projection of the data signal line 25 on the base substrate, and the second insulating layer and the first insulating layer within the eighth via V8 are etched off to expose a surface of the data signal line 25. In an exemplary embodiment, the eighth via V8 is configured such that a subsequently formed auxiliary data line is connected with the data signal line 25 through the via. In an exemplary embodiment, the eighth via V8 may include a plurality, and the plurality of eighth via V8 may be sequentially arranged along the second direction Y to increase reliability of a connection between the data signal line 25 and the auxiliary data line.

In an exemplary embodiment, a ninth via V9 may be provided in each sub-pixel, an orthographic projection of the ninth via V9 on the base substrate is within a range of an orthographic projection of the second electrode plate 34 on the base substrate, and the second insulating layer within the ninth via V9 is etched off to expose a surface of the second electrode plate 25. In an exemplary embodiment, the ninth via V9 is configured such that a gate electrode of the subsequently formed second transistor T2 is connected with the second electrode plate 34 through the via.

In an exemplary embodiment, the plurality of first connection vias K1 described above may include the third via V3, the sixth via V6, and the ninth via V9, and the plurality of second connection vias K2 described above may include the first via V1, the fourth via V4, and the fifth via V5.

In an exemplary implementation mode, this process further includes a conductorization treatment. The conductorization treatment is a plasma treatment performed using the second insulating layer as a shield after the pattern of the second insulating layer is formed, a region of the semiconductor layer, which is shielded by the second insulating layer, is not conductorized, and a region of the semiconductor layer in the plurality of vias, which is not shielded by the second insulating layer, is processed into a conductorized layer. The conductorization treatment of the first conductorized region d1 and the second conductorized region d2 described above is completed in this process.

(15) A pattern of a third conductive layer is formed. In an exemplary embodiment, forming a pattern of a third conductive layer may include depositing a third conductive thin film on the base substrate on which the above-mentioned patterns are formed, patterning the third conductive thin film by a patterning process to form a pattern of a third conductive layer disposed on the second insulating layer, wherein the pattern of the third conductive layer includes at least a first scan signal line 41, a second gate electrode 42, a first power supply connection line 43, a first power supply auxiliary line 44, an auxiliary data line 45, a second transfer connection electrode 47, a third transfer connection electrode 48, and a fourth transfer connection electrode 411, as shown in FIGS. 10a and 10b, where FIG. 10b is a schematic plan view of the third conductive layer in FIG. 10a. In an exemplary embodiment, the third conductive layer may be referred to as a gate metal (GATE) layer.

In an exemplary implementation mode, the first scan signal line 41 is in a structure of a strip with a main body portion extending along the first direction X, and in the second direction Y, the first scan signal line 41 is located at a side of the second electrode plate 34 away from an active layer of the second transistor T2. The first scan signal line 41 is provided across the first sub-pixel P1 to the fourth sub-pixel P4, and a first gate electrode 41-1 and a third gate electrode 41-3 are provided on the first scan signal line 41 of each sub-pixel, the first gate electrode 41-1 serves as a gate electrode of the first transistor T1, and there is an overlapping region between an orthographic projection of the first gate electrode 41-1 on the base substrate and an orthographic projection of the active layer 31 of the first transistor T1 on the base substrate; the third gate electrode 41-3 serves as a gate electrode of the third transistor T31, and there is an overlapping region between an orthographic projection of the third gate electrode 41-3 on the base substrate and an orthographic projection of the active layer 33 of the third transistor T3 on the base substrate. In an exemplary implementation mode, in the second direction Y, the first gate electrode 41-1 and the third gate electrode 41-3 may be located on two sides of a main body portion of the first scan signal line 41, and the third gate electrode 41-3 is located on a side of the main body portion of the first scan signal line 41 away from the second electrode plate 34. In an exemplary implementation mode, the first scan signal line 41 is provided to be shared by the third transistor T2 and the first transistor T1, thereby saving space.

In the exemplary embodiment, a second gate electrode 42 is formed within each sub-pixel as a gate electrode of the second transistor T2. In each sub-pixel, on the one hand, there is an overlapping region between an orthographic projection of the second gate electrode 42 on the base substrate and an orthographic projection of the active layer 32 of the second transistor T2 on the base substrate, and on the other hand, there is an overlapping region between an orthographic projection of the second gate electrode 42 on the base substrate and an orthographic projection of the second electrode plate 34 on the base substrate. The second gate electrode 42 is in a structure of a strip extending in the first direction X, and in the second direction Y, the second gate electrode 42 is located at a side of the second electrode plate 34 away from the first scan signal line 41. The second gate electrode 42 may be connected to the second electrode plate 34 through the ninth via V9 such that the second gate electrode 42 has the same potential as the second electrode plate 34.

In an exemplary implementation mode, the first power supply connection line 43 may be in a structure of a strip extending in the first direction X, and the first power supply connection line 43 may be disposed across the first sub-pixel P1 to the fourth sub-pixel P4 and be integrally formed with the first power supply auxiliary line 44; In the second direction Y, the first power supply connection line 43 may be located at a side of the second gate electrode 42 away from the second electrode plate 34. An orthographic projection of the first power supply connection line 43 on the base substrate at least partially overlaps an orthographic projection of the active layer 32 of the second transistor T2 on the base substrate, and the first power supply connection line 43 can be electrically connected to the active layer 32 of the second transistor T2 through the third via V3 to provide the first power supply signal to the second transistor T2. In an exemplary implementation mode, the first power supply connection line 43 may be reused as the first electrode of the second transistor T2.

In an exemplary implementation mode, the first power supply auxiliary line 44 is formed within the first sub-pixel P1 and the fourth sub-pixel P4, and is in a structure of a strip extending in the second direction Y. In the first sub-pixel P1, in the first direction X, the first power supply auxiliary line 44 is located at a side of the second electrode plate 34 away from the second sub-pixel P2. In the fourth sub-pixel P4, in the first direction X, the first power supply auxiliary line 44 is located at a side of the second electrode plate 34 away from the third sub-pixel P3. The first power supply auxiliary line 44 is configured to be connected to the first power supply line 21 through the seventh via V7 to form a double-layer trace, to ensure reliability of transmission of a power supply signal, and to reduce a resistance of the first power supply line 21.

In an exemplary implementation mode, an auxiliary data line 45 is formed within each sub-pixel and is in a structure of a strip extending in the second direction Y. Within the first sub-pixel P1 and the third sub-pixel P3, auxiliary data lines 45 are located on a side of the second electrode plate 34 in the first direction X. Within the second sub-pixel P2 and the fourth sub-pixel P4, auxiliary data lines 45 are located on a side of the second electrode plate 34 in an opposite direction of the first direction X. The auxiliary data line 45 is configured to be connected with the data signal line 25 to form a double-layer trace to ensure reliability of transmission of a data signal and to reduce a resistance of the data signal line.

In an exemplary implementation mode, the main body portions of the first power supply auxiliary line 44 and the auxiliary data line 45 may be arranged in parallel.

In an exemplary implementation mode, a second transfer connection electrode 47 is formed in each sub-pixel, an orthographic projection of the second transfer connection electrode 47 on the base substrate, on the one hand, at least partially overlaps an orthographic projection of the second region 32-2 of the active layer 32 of the second transistor T2 on the base substrate, and on the other hand, at least partially overlaps an orthographic projection of the shield structure 23 on the base substrate, the second transfer connection electrode 47 is configured to be connected to the second region 32-2 of the active layer 32 of the second transistor T2 and the shield structure 23 through the second via V4. In an exemplary implementation mode, the second transfer connection electrode 47 may serve as a second electrode of the second transistor T2.

In an exemplary implementation mode, a third transfer connection electrode 48 is formed in each sub-pixel, an orthographic projection of the third transfer connection electrode 48 on the base substrate at least partially overlaps an orthographic projection of the second region 33-2 of the active layer 33 of the third transistor T3 on the base substrate, and the third transfer connection electrode 48 is configured to be connected to the second region 33-2 of the active layer 33 of the third transistor T3 through the sixth via V6. In an exemplary implementation mode, the third transfer connection electrode 48 may serve as a second electrode of the third transistor T3.

In an exemplary implementation mode, the fourth transfer connection electrode 411 is provided between the second sub-pixel P2 and the third sub-pixel P3, an orthographic projection of the fourth transfer connection electrode 411 on the base substrate is at least partially overlapped with an orthographic projection of the compensation signal line 22 on the base substrate on the one hand, and at least partially overlapped with an orthographic projection of the compensation connection line 35 on the base substrate on the other hand, the fourth transfer connection electrode 411 is configured to be connected to the compensation signal line 22 and the compensation connection line 35 through the fifth via V5, and the fourth transfer connection electrode 411 may serve as a first electrode of the third transistor T3.

In an exemplary implementation mode, this process further includes a conductorization treatment. The conductorization treatment is a plasma treatment performed using the third conductive layer as a shield after the pattern of the third conductive layer is formed, a region of the semiconductor layer, which is shielded by the first gate electrode, the second gate electrode and the third gate electrode, servers as a channel region of the transistor, and a region of the semiconductor layer, which is not shielded by the third conductive layer is processed into a conductorized layer to form a conductorized second electrode plate 34 and a conductorized source-drain region. The conductorization treatment of the third conductorized region described above is completed by this process.

(16) Patterns of a third insulation layer and a planarization layer are formed. In an exemplary embodiment, forming a pattern of a planarization layer may include sequentially coating a third insulating thin film and a planarization thin film on the base substrate on which the above-mentioned patterns are formed, patterning the third insulating thin film and the planarization thin film using a patterning process to form a third insulating layer and a pattern of a planarization layer covering the third conductive layer, a plurality of vias are provided on the third insulating layer and the planarization layer, the plurality of vias include at least a twentieth via V20 and a twenty-first via V21 located in each sub-pixel, as shown in FIG. 11.

In an exemplary implementation mode, a twentieth via V20 may be provided in each sub-pixel, an orthographic projection of the twentieth via V20 on the base substrate is within a range of an orthographic projection of the third transfer connection electrode 48 on the base substrate, and the planarization layer and the third insulating layer within the twentieth via V20 are removed to expose a surface of the third transfer connection electrode 48. In an exemplary embodiment, the twentieth via V20 is configured such that a subsequently formed anode is connected with the third transfer connection electrode 48 through the via.

In an exemplary implementation mode, the twenty-first via V21 may be provided in each sub-pixel, an orthographic projection of the twenty-first via V21 on the base substrate is within a range of an orthographic projection of the second transfer connection electrode 47 on the base substrate, and the planarization layer and the third insulating layer within the twenty-first via V21 are removed to expose a surface of the second transfer connection electrode 47. In an exemplary embodiment, the twenty-first via V21 is configured so that the anode formed subsequently is connected to the second transfer connection electrode 47 through the via.

So far, a drive circuit layer has been prepared on the base substrate. In a plane parallel to the display substrate, the drive circuit layer may include multiple sub-pixels, each sub-pixel may include a pixel drive circuit, and a first scan signal line, a first power supply line, a data signal line, and a compensation signal line connected to the pixel drive circuit. In a plane perpendicular to the display substrate, the drive circuit layer may include a first conductive layer, a second conductive layer, a first insulating layer, a semiconductor layer, a second insulating layer, a third conductive layer, a third insulating layer and a planarization layer that are sequentially stacked on the base substrate.

In an exemplary embodiment, after the preparation of the drive circuit layer is completed, a light emitting structure layer is prepared on the drive circuit layer, and the preparation process of the light emitting structure layer may include the following acts:

(17) A pattern of a fourth conductive layer is formed. In an exemplary embodiment, forming a pattern of a fourth conductive layer may include depositing a fourth conductive thin film on the base substrate on which the above-mentioned patterns are formed, patterning the fourth conductive thin film using a patterning process to form a pattern of a fourth conductive layer disposed on the planarization layer, the pattern of the fourth conductive layer include at least an anode 301 located in each sub-pixel, as shown in FIGS. 12a and 12b, where FIG. 12b is a schematic plan view of the fifth conductive layer in FIG. 12a. In an exemplary embodiment, the fourth conductive layer may be referred to as a second transparent (ITO2) layer.

In an embodiment of the present disclosure, the second transparent layer may be the transparent conductive layer described above.

In an exemplary implementation mode, the pattern of the fourth conductive layer may include a first anode 301R located in the first sub-pixel P1, a second anode 301W located in the second sub-pixel P2, a third anode 301G located in the third sub-pixel P3, and a fourth anode 301B located in the fourth sub-pixel P4. An anode 301 in each sub-pixel is connected to a third transfer connection electrode 48 through a twentieth via V20. Since the third transfer connection electrode 48 servers as a second electrode of the third transistor T3, the connection of the anode 301 with the third transistor T3 is realized. An anode 301 in each sub-pixel is connected to a second transfer connection electrode 47 through a twenty-first via V21. Since the second transfer connection electrode 47 is used as the second electrode of the second transistor T2, the connection of the anode 301 with the second transistor T2 is implemented.

In an exemplary implementation mode, the first anode 301R, the second anode 301W, the third anode 301B, and the fourth anode 301G may be in a strip shape extending in the second direction Y. In the second direction Y, a first connection electrode 3011 and a second connection electrode 3012 are respectively provided on two sides of an anode in each sub-pixel, the first connection electrode 3011 is connected to the third transfer connection electrode 48 through the twentieth via V20, and the second connection electrode 3012 is electrically connected to the second transfer connection electrode 47 through the twenty-first via V21. The anode and the first connection electrode 3011 and the second connection electrode 3012 in each sub-pixel may be of an integrally formed structure.

In an exemplary implementation mode, an orthographic projection of an anode in each sub-pixel on the base substrate contains an orthographic projection of a storage capacitor in a sub-pixel where the anode is located on the base substrate.

In an exemplary implementation mode, the twentieth via V20 may serve as the above-described second transfer via, and the twenty-first via V21 may serve as the above- described first transfer via.

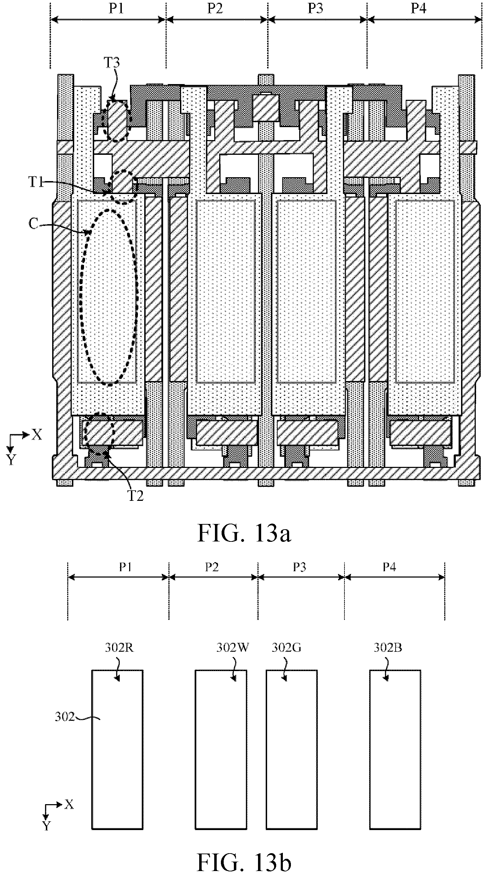

(18) A pattern of a pixel definition layer is formed. In an exemplary embodiment, forming the pixel definition layer pattern may include: coating a pixel define film on the base substrate on which the aforementioned patterns are formed, and patterning the pixel define film through a patterning process to form a pattern of a pixel definition layer 302 including at least a pixel opening in each sub-pixel, as shown in FIGS. 13a and 13b, where FIG. 13b is a schematic plan view of the pixel definition layer in FIG. 13a.

In an exemplary embodiment, the pattern of pixel definition layer 302 may include a red pixel opening 302R in the first sub-pixel P1 exposing the red anode 301R, a white pixel opening 302W in the second sub-pixel P2 exposing the white anode 301W, a green opening 302G in the third sub-pixel P3 exposing the green anode 301G, and a blue pixel opening 302B in the fourth sub-pixel P4 exposing the blue anode 301B.

In an exemplary embodiment, the shape and area of the pixel openings of different sub-pixels may be different. In the exemplary embodiment of the present disclosure, four sub-pixels are designed with different aperture ratios, transmittances of color film layers of different sub-pixels may be adapted, so that light emitting devices of the four sub-pixels may emit same brightness at different currents, service life of the light emitting devices of the four sub-pixels is optimized to a maximum extent, and thereby ensuring service life of a product.

In an exemplary embodiment, an orthographic projection of a pixel opening in each sub-pixel on the base substrate at least partially overlaps an orthographic projection of a storage capacitor of the sub-pixel on the base substrate.

In an exemplary implementation mode, a subsequent manufacturing process may include: forming an organic emitting layer using an evaporation or inkjet printing process, wherein the organic emitting layer is connected with an anode through a pixel opening, and forming a cathode on the organic emitting layer, wherein the cathode is connected with the organic emitting layer. An encapsulation layer is formed, wherein the encapsulation layer may include a first encapsulation layer, a second encapsulation layer, and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer to ensure that external water vapor cannot enter the light emitting structure layer.

In some exemplary embodiments, the first conductive layer and the fourth conductive layer may be made of a transparent conductive material, such as Indium Tin Oxide (ITO) and Indium Zinc Oxide (IZO). The second conductive layer, the third conductive layer, and the third conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer is referred to as a Buffer layer, the second insulation layer is referred to as a Gate Insulator (GI), and the third insulation layer is referred to as an Interlayer Dielectric (PVX) layer. The planarization layer may be made of an organic material such as resin. The pixel definition layer may be made of polyimide, acrylic or polyethylene terephthalate.

The display substrate prepared by the above acts (11) to (18) is composed of 6 array substrate masks (Array MASK) and 5 color film substrate masks (CF MASK), wherein the Array MASK includes samples of a first conductive layer (CF_ITO), a shield metal layer (SHIELD), a semiconductor layer (ACT), a second insulating layer (GI), a gate metal layer (GT), and a sixth conductive layer (ITO), and 5 CF MASKs include a planarization layer (RESIN), a pixel definition layer (PDL), a red light emitting layer (Red), a green light emitting layer (Green), and a blue light-emitting layer (Blue). The quantity of masks used is small, and the preparation process is simplified to reduce the preparation cost. Compared with the pixel design in related technologies, the trace of the data signal line and the first power supply line VDD is changed from the source-drain metal layer SD to the shield layer SHIELD. This eliminates the MASK of the source-drain metal layer SD layer, further removes CNT holes and ILD holes, and adds GI holes. The planarization layer (RESIN) and the third insulating layer PVX layer share a MASK, which greatly simplifies the preparation process and reduces the preparation cost. The GT layer and the ACT layer, the GT layer and the SHIELD layer are connected to each other through the GI holes. In addition, the data signal line uses a SHIELD and GT double-layer wiring to reduce the impedance of the data signal line, the first power supply line VDD uses a SHIELD and GT double-layer wiring in the longitudinal direction (the second direction Y) to reduce the impedance, and reduce the RC of the first power supply line and the data signal line, the capacitor uses a transparent capacitor CF_ITO/SHIELD-ACT capacitor structure, wherein CF_ITO and SHIELD are directly contacted and electrically connected to each other, and RGB capacitors are the same size.

In an exemplary embodiment, taking four sub-pixels (first sub-pixel P1, second sub-pixel P2, third sub-pixel P3, and fourth sub-pixel P4) as an example, another preparation process of the drive circuit layer may include the following operations.

(21) A pattern of a first conductive layer is formed. In an exemplary implementation mode, forming a pattern of a first conductive layer may include depositing a first conductive thin film on a base substrate, patterning the first conductive thin film by a patterning process to form a pattern of a first conductive layer on the base substrate, the pattern of the first conductive layer including at least a first electrode plate 11 formed in each sub-pixel, as shown in FIG. 14. In an exemplary embodiment, a first conductive layer may be referred to as a first transparent (ITO1) layer.

In an exemplary implementation mode, the first electrode plate 11 in each sub-pixel is configured to form a transparent electrode plate of a storage capacitor, the first electrode plate 11 may be in a shape of a rectangle, and edges of the rectangle may be of a polyline. In an exemplary implementation mode, a size of a first electrode plate 11 located in the second sub-pixel P2 and the third sub-pixel P3 in the second direction Y is less than a size of a first electrode plate located in the first sub-pixel P1 and the fourth sub-pixel P4 in the second direction Y.

(22) A pattern of a second conductive layer is formed. In an exemplary implementation mode, forming a pattern of a second conductive layer may include depositing a second conductive thin film on the base substrate on which the above-mentioned patterns are formed, patterning the second conductive thin film by a patterning process to form a pattern of a second conductive layer covering the first conductive layer, the pattern of the second conductive layer including at least a first scan signal line 41, as shown in FIG. 15, which is a schematic plan view of the second conductive layer and the first conductive layer. In an exemplary embodiment, the second conductive layer may be referred to as a first shield metal (SHL1) layer.

In an exemplary implementation mode, a first scan signal line 41 is in a structure of a strip extending along the first direction X, and the first scan signal line 41 is disposed across the first sub-pixel P1 to the fourth sub-pixel P4 in the first direction X. In the second direction Y, the first scan signal line 41 is located at a side of the first electrode plate 11.

(23) A pattern of a third conductive layer is formed. In an exemplary implementation mode, forming a pattern of a third conductive layer may include depositing a third conductive thin film on the base substrate on which the above-mentioned patterns are formed, patterning the third conductive thin film by a patterning process to form a pattern of a third conductive layer on the base substrate, the pattern of the third conductive layer including at least a shield structure 23, a first scan signal auxiliary line 410, a compensation connection line 35, and a first auxiliary data line 451, as shown in FIGS. 16a and 16b, where FIG. 16b is a schematic plan view of the third conductive layer in FIG. 16a. In an exemplary embodiment, the third conductive layer may be referred to as a second shielding metal (SHL2) layer.

In an exemplary implementation mode, a shield structure 23 may be provided in each sub-pixel, the shield structure 23 may be of a rectangular structure, and the rectangular structure may be provided with chamfered corners. In the second direction Y, the shield structure 23 may be located at a side of the first auxiliary data line 451 away from the first scan signal auxiliary line 410. In an exemplary implementation mode, an orthographic projection of the shield structure 23 on the base substrate overlaps at least partially with an orthographic projection of the first electrode plate 11 on the base substrate, and the shield structure 23 is connected to the first electrode plate.

In an exemplary implementation mode, the first scan signal auxiliary line 410 is in a structure of a strip extending along the first direction X and the first scan signal line 41 is disposed across the first sub-pixel P1 to the fourth sub-pixel P4 in the first direction X. In the second direction Y, the first scan signal line 41 is located at a side of the first electrode plate 11 and between the first electrode plate 11 and the compensation connection line 35. In an exemplary implementation mode, an orthographic projection of the first scan signal auxiliary line 410 on the base substrate overlaps at least partially with an orthographic projection of the first scan signal line 41 on the base substrate, and the first scan signal auxiliary line 410 is arranged to be connected to the first scan signal line 41 to form a double-layer trace to reduce a resistance of the scan signal line 41.

In an exemplary implementation mode, in the second direction Y, the compensation connection line 35 is located at a side of the first scan signal auxiliary line 410 away from the first electrode plate 11, the compensation connection line 35 may be in a structure of a strip extending in the first direction X, and in the first direction X, the compensation connection line 35 is disposed across the first sub-pixel P1 to the fourth sub-pixel P4.

In an exemplary implementation mode, a first auxiliary data line 451 is provided at each sub-pixel respectively, and the first auxiliary data line 451 may be in a structure of a strip extending along the second direction Y, and the first auxiliary data line 451 may be located between the first scan signal auxiliary line 410 and the shield structure 23 in the second direction Y. In an exemplary implementation mode, the first auxiliary data line 451 is provided to be electrically connected to the subsequently formed data signal line 25 to form a double-layer trace to reduce a resistance of the data signal line.

(24) A pattern of a semiconductor layer is formed. In an exemplary implementation mode, forming a pattern of a semiconductor layer may include sequentially depositing a first insulating thin film and a semiconductor thin film on the base substrate, patterning the semiconductor thin film by a patterning process to form a first insulating layer covering the third conductive layer, and a pattern of a semiconductor layer disposed on the first insulating layer, the pattern of the semiconductor layer including at least an active layer 31 of the first transistor T1, an active layer 32 of the second transistor T2, an active layer 33 of the third transistor T3, a second electrode plate 34, and a first power supply connection line 43 formed in each sub-pixel, as shown in FIGS. 17a and 17b, where FIG. 17b is a schematic plan view of the semiconductor layer in FIG. 17a.

In an exemplary embodiment, there is an overlapping region between an orthographic projection of the second electrode plate 34 on the base substrate and an orthographic projection of the first electrode plate 11 on the base substrate in each sub-pixel, the second electrode plate 34 is configured as another transparent electrode plate that forms a storage capacitor, and the first electrode plate 11 and the second electrode plate 34 form a transparent storage capacitor.

In an exemplary implementation mode, the second electrode plate 34 may be in a shape of a rectangle, and edges of the rectangle may be of a polyline.

In an exemplary implementation mode, in each sub-pixel, the shape of the second electrode plate 34 may be similar to the shape of the first electrode plate 11 in the sub-pixel where the second electrode plate 34 is located, and an orthographic projection of the second electrode plate 34 on the base substrate may cover an orthographic projection of the first electrode plate 11 on the base substrate.

In an exemplary implementation mode, the active layer 31 of the first transistor T1, the active layer 32 of the second transistor T2, and the active layer 33 of the third transistor T3 each include a channel region and first and second regions located at two sides of the channel region.

In an exemplary implementation mode, the active layer 31 of the first transistor T1 may be "L"-shaped, and the active layer 31 of the first transistor T1 may be located on a side of the second electrode plate 34 in the second direction Y.

In an exemplary implementation mode, the second region 31-2 of the active layer 31 of the first transistor T1 may be connected to the second electrode plate 34, and the active layer 31 of the first transistor T1 and the second electrode plate 34 are of an interconnected integral formed structure.

In an exemplary implementation mode, the first region 31-1 of the active layer 31 of the first transistor T1 is in a structure of a strip extending in the first direction X, and the structure of a strip extends from the second region 31-2 of the active layer 31 of the first transistor T1 towards an adjacent sub-pixel. The structure of a strip in the first sub-pixel P1 extends towards the second sub-pixel P2, and the structure of a strip in the third sub-pixel P3 extends towards the fourth sub-pixel P4; the structure of a strip in the second sub-pixel P2 extends towards the first sub-pixel P1, and the structure of a strip in the fourth sub-pixel P3 extends towards the third sub-pixel P3. Since the second region 31-2 of the active layer 31 of the first transistor T1 is electrically connected to a gate electrode of the second transistor T2 through a second electrode of the first transistor T1 formed subsequently, the interconnection between the second electrode of the first transistor T1, the gate electrode of the second transistor T2, and the second electrode plate of the storage capacitor is realized.

In an exemplary implementation mode, the active layer 32 of the second transistor T2 may be "T"-shaped, and in the second direction Y, the second active layer 32 may be located at a side of the second electrode plate 34 away from the active layer 31 of the first transistor T1. An orthographic projection of the active layer 32 of the second transistor T2 on the base substrate is spaced apart from an orthographic projection of the second electrode plate 34 on the base substrate, that is, there is no overlapping region between the second active layer 32 and the second electrode plate 34, which is beneficial to design the channel width to length ratio of the second transistor according to the relevant requirements. The first region 32-1 of the active layer 32 of the second transistor T2 is located on a side of the channel region away from the second electrode plate 34, and there is an overlapping region between an orthographic projection of a portion of the first region 32-1 of the active layer 32 of the second transistor T2 on a side close to the channel region on the base substrate and an orthographic projection of the shield structure 23 on the base substrate. The second region 32-2 of the active layer 32 of the second transistor T2 is located on a side of the channel region close to the second electrode plate 34, and there is an overlapping region between an orthographic projection of the second region 32-2 of the active layer 32 of the second transistor T2 on the base substrate and an orthographic projection of the shield structure 23 on the base substrate. In this way, the shield structure 23 can shield the channel region of the second active layer 32 to avoid the influence of light on the channel and reduce the leakage current, thereby avoiding the influence of light on the transistor characteristics. In an exemplary implementation mode, first regions of the active layers 32 of the second transistors T2 of a plurality of sub-pixels in a same pixel unit and the first power supply connection line 43 may be of an interconnected integral structure.

In an exemplary implementation mode, the active layer 33 of the third transistor T3 may be "I"-shaped, and in the second direction Y, the active layer 33 of the third transistor T3 may be located on a side of the active layer 31 of the first transistor T1 away from the second electrode plate 34. An orthographic projection of the active layer 33 of the third transistor T3 on the base substrate is spaced apart from an orthographic projection of the second electrode plate 34 on the base substrate, that is, there is no overlapping region between the third active layer 33 and the second electrode plate 42, which is conducive to designing the width-length ratio of the channel of the third transistor according to the relevant requirements. In an exemplary implementation mode, in the second direction Y, the active layer 31 of the first transistor T1 and the active layer 33 of the third transistor T3 are located at two sides of the first scan signal auxiliary line 410.

In an exemplary implementation mode, the first power supply connection line 43 may be in a structure of a strip extending in the first direction X, and the first power supply connection point 43 may be disposed across the first sub-pixel P1 to the fourth sub-pixel P4 and be integrally formed with the active layer 33 of the third transistor T3; in the second direction Y, the first power supply connection line 43 may be located on a side of the active layer 32 of the second transistor T2 away from the second electrode plate 34.

In an exemplary implementation mode, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or multiple layers.

(25) A pattern of a fourth conductive layer is formed. In an exemplary implementation mode, forming a pattern of a fourth conductive layer may include sequentially depositing a second insulating thin film and a fourth conductive thin film on the base substrate, patterning the second insulating thin film and the fourth conductive thin film by a patterning process to form a second insulating layer covering the semiconductor layer, and a pattern of a fourth conductive layer disposed on the second insulating layer, the pattern of the fourth conductive layer including at least a second gate electrode 42, a first power supply auxiliary line 44, a second auxiliary data line 452, and a first gate electrode 49, as shown in FIGS. 18a and 18b, where FIG. 18b is a schematic plan view of the fourth conductive layer in FIG. 18a. In an exemplary implementation mode, the fourth conductive layer may be referred to as a gate metal (GATE) layer.

In the exemplary implementation mode, a second gate electrode 42 is formed within each sub-pixel as a gate electrode of the second transistor T2. In each sub-pixel, on the one hand, there is an overlapping region between an orthographic projection of the second gate electrode 42 on the base substrate and an orthographic projection of the active layer 32 of the second transistor T2 on the base substrate, and on the other hand, there is an overlapping region between an orthographic projection of the second gate electrode 42 on the base substrate and an orthographic projection of the shield structure 23 on the base substrate. The second gate electrode 42 is in a structure of a strip extending in the first direction X, and in the second direction Y, the second gate electrode 42 is located at a side of the second electrode plate 34 away from the first transistor T1.

In an exemplary implementation mode, the first power supply auxiliary line 44 is formed within the first sub-pixel P1 and the fourth sub-pixel P4, and is in a structure of a strip extending in the second direction Y. In the first sub-pixel P1, in the first direction X, the first power supply auxiliary line 44 is located at a side of the second electrode plate 34 away from the second sub-pixel P2. In the fourth sub-pixel P4, in the first direction X, the first power supply auxiliary line 44 is located at a side of the second electrode plate 34 close to the third sub-pixel P3. The second power supply auxiliary line 452 is configured to be connected to the first power supply line formed subsequently to form a double-layer trace, to ensure the reliability of transmission of a power supply signal, and to reduce a resistance of the first power supply line.

In an exemplary implementation mode, a second auxiliary data line 452 is formed within each sub-pixel and is in a structure of a strip extending in the second direction Y. Within the first sub-pixel P1 and the third sub-pixel P3, second auxiliary data lines 452 are located at a side of the second electrode plate 34 in the first direction X. Within the second sub-pixel P2 and the fourth sub-pixel P4, second auxiliary data lines 452 are located on a side of the second electrode plate 34 in an opposite direction of the first direction X. The second auxiliary data line 452 is configured to be connected with the first auxiliary data line 451 and the data signal line formed subsequently to form a three-layer trace, to ensure the reliability of transmission of a data signal, and to reduce a resistance of the data signal line. In an exemplary implementation mode, there is an overlapping region between an orthographic projection of the second auxiliary data line 452 on the base substrate and an orthographic projection of the first auxiliary data line 451 on the base substrate.

In an exemplary implementation mode, the main body portions of the first power supply auxiliary line 44 and the second auxiliary data line 452 may be arranged in parallel.

In an exemplary implementation mode, a first gate electrode 49 is formed within each sub-pixel as a gate electrode of the first transistor T1 and the third transistor T3. In each sub-pixel, on the one hand, there is an overlapping region between an orthographic projection of the first gate electrode 49 on the base substrate and an orthographic projection of the active layer 32 of the first transistor T1 on the base substrate, and on the other hand, there is an overlapping region between an orthographic projection of the first gate electrode 49 on the base substrate and an orthographic projection of an active layer of the third transistor T3 on the base substrate. The first gate electrode 49 is in a structure of a strip and a structure of a polyline extending in the second direction Y, and the first gate electrode 49 is located at a side of the second electrode plate 34 away from the second transistor T2 in the second direction Y. In the first sub-pixel P1 and the fourth sub-pixel P4, the first gate electrode 49 is in a structure of a strip, and in the second sub-pixel P2 and the third sub-pixel P3, the first gate electrode 49 is in a structure of a polyline.

In an exemplary implementation mode, this process further includes a conductorization treatment. The conductorization treatment is a plasma treatment performed using the third conductive layer as a shield after the pattern of the third conductive layer is formed, a region of the semiconductor layer, which is shielded by the first gate electrode and the second gate electrode, servers as a channel region of the transistor, and a region of the semiconductor layer, which is not shielded by the third conductive layer is processed into a conductorized layer to form a conductorized second electrode plate 34 and a conductorized source-drain region.

(26) A pattern of a third insulation layer is formed. In an exemplary embodiment, forming a pattern of a third insulating layer may include: depositing a third insulating thin film on the base substrate on which the above-mentioned patterns are formed, patterning the third insulating thin film using a patterning process to form a third insulating layer covering the fourth conductive layer, a plurality of vias are provided on the third insulating layer, the plurality of vias including at least a first via V1, a second via V2, a third via V3, a fourth via V4, a fifth via V5, a sixth via V6, a seventh via V7, an eighth via V8, a ninth via V9, a tenth via V10, an eleventh via V11, and a twelfth via V12, as shown in FIG. 19.

In an exemplary embodiment, a first via V1 may be provided in each sub-pixel, an orthographic projection of the first via V1 on the base substrate is within a range of an orthographic projection of the first region 31-1 of the active layer 31 of the first transistor T1 on the base substrate, and the third and second insulating layers within the first via V1 are etched off to expose a surface of the first region 31-1 of the active layer 31 of the first transistor T1. In an exemplary embodiment, the first via V1 is configured such that a subsequently formed data signal line is connected with the active layer 31 of the first transistor T1 through the via.

In an exemplary embodiment, a second via V2 may be provided in each sub-pixel, an orthographic projection of the second via V2 on the base substrate is within a range of an orthographic projection of the second region 31-2 of the active layer 31 of the first transistor T1 on the base substrate, and the third and second insulating layers within the second via V2 are etched off to expose a surface of the second region 31-2 of the first active layer 31 simultaneously. In an exemplary embodiment, the second via V2 is configured such that a second electrode of the first transistor T1 formed subsequently is connected with the active layer 31 of the first transistor T1 through the via.

In an exemplary embodiment, a third via V3 may be provided in each sub-pixel, an orthographic projection of the third via V3 on the base substrate is within a range of an orthographic projection of the first region 32-1 of the active layer 32 of the second transistor T2 on the base substrate, and the third insulating layer and the second insulating layer within the third via V3 are etched off to expose a surface of the first region 32-1 of the active layer 32 of the second transistor T2. In an exemplary embodiment, the third via V3 is configured such that the first power supply line formed subsequently is electrically connected with the active layer 32 of the second transistor T2.

In an exemplary embodiment, a fourth via V4 may be provided in each sub-pixel, an orthographic projection of the fourth via V4 on the base substrate at least partially overlaps, on the one hand, an orthographic projection of the second region 32-2 of the active layer 32 of the second transistor T2 on the base substrate, and on the other hand, at least partially overlaps an orthographic projection of the shield structure 23 on the base substrate, and the third insulating layer, the second insulating layer, and the first insulating layer within the fourth via V4 are etched off to expose a surface of the second region 32-2 of the active layer 32 of the second transistor T2 and a surface of the shield structure 23 simultaneously. In an exemplary embodiment, the second region 32-2 is configured such that a second electrode of the subsequently formed second transistor T2 is simultaneously connected to the shield structure 23 and the active layer 32 of the second transistor T2 through the via.

In an exemplary embodiment, a fifth via V5 may be provided in each sub-pixel, an orthographic projection of the fifth via V5 on the base substrate at least partially overlaps an orthographic projection of the first region 33-1 of the active layer 33 of the third transistor T3 on the base substrate, and the third insulating layer and the second insulating layer within the fifth via V5 are etched off to expose a surface of the first region 33-1 of the active layer 33 of the third transistor T3. In an exemplary embodiment, the fifth via V5 is configured such that a first electrode of the subsequently formed third transistor T3 is connected with the active layer 33 of the third transistor T2 through the via.

In an exemplary embodiment, a sixth via V6 may be provided in each sub-pixel, an orthographic projection of the sixth via V6 on the base substrate at least partially overlaps an orthographic projection of the second region 33-2 of the active layer 33 of the third transistor T3 on the base substrate, and the third insulating layer and the second insulating layer within the sixth via V6 are etched off to expose a surface of the second region 33-2 of the active layer 33 of the third transistor T3. In an exemplary embodiment, the sixth via V6 is configured such that a second electrode of the subsequently formed third transistor T3 is connected with the active layer 33 of the third transistor T2 through the via.

In an exemplary embodiment, a seventh via V7 may be provided in the first sub-pixel P1 and the fourth sub-pixel P4, an orthographic projection of the seventh via V7 on the base substrate is within a range of an orthographic projection of the first power supply auxiliary line 44 on the base substrate, and the third insulating layer within the seventh via V7 is etched off to expose a surface of the first power supply auxiliary line 44. In an exemplary embodiment, the seventh via V7 is configured such that a first power supply line formed subsequently is connected with the first power supply auxiliary line 44 through the via. In an exemplary embodiment, a plurality of seventh vias V7 may be provided, and the plurality of seventh vias V7 may be sequentially arranged in the second direction Y to increase reliability of a connection between the first power supply line and the first power supply auxiliary line 44.

In an exemplary embodiment, an eighth via V8 may be provided in the first sub-pixel P1 and the fourth sub-pixel P4, an orthographic projection of the eighth via V8 on the base substrate is within a range of an orthographic projection of the compensation connection line 35 on the base substrate, and the third insulating layer, the second insulating layer, and the first insulating layer within the eighth via V8 are etched off to expose a surface of the compensation connection line 35. In an exemplary embodiment, the eighth via V8 is configured such that a first electrode of the subsequently formed third transistor T3 is connected with the compensation connection line 35 through the via.

In an exemplary embodiment, a ninth via V9 may be provided in each sub-pixel, an orthographic projection of the ninth via V9 on the base substrate is located within a range of an orthographic projection of the first scan signal auxiliary line 410 on the base substrate on the one hand, and is located within a range of an orthographic projection of the first gate electrode 49 on the base substrate on the other hand, the third insulating layer, the second insulating layer, and the first insulating layer within the ninth via V9 are etched off to expose a surface of the first scan signal auxiliary line 410 and a surface of the first gate electrode 49. In an exemplary embodiment, the ninth via V9 is configured such that a subsequently formed gate transfer connection electrode is connected with the first scan signal auxiliary line 410 and the first gate electrode 49 through the via.

In an exemplary embodiment, a tenth via V10 may be provided in each sub-pixel, an orthographic projection of the tenth via V10 on the base substrate is located within a range of an orthographic projection of the second gate electrode 42 on the base substrate on the one hand, and is located within a range of an orthographic projection of the second electrode plate 34 on the base substrate on the other hand, the third insulating layer and the second insulating layer within the tenth via V10 are etched off to expose surfaces of the second electrode plate 34 and the second gate electrode 42. In an exemplary embodiment, the tenth via V10 is configured such that a second electrode of the subsequently formed second transistor T2 is connected with the second gate electrode 42 and the second electrode plate 34.

In an exemplary embodiment, an eleventh via V11 may be provided in each sub-pixel, an orthographic projection of the eleventh via V11 on the base substrate is within a range of an orthographic projection of the second auxiliary data line 452 on the base substrate, and the third insulating layer within the eleventh via V11 is etched off to expose a surface of the second auxiliary data line 452. In an exemplary embodiment, the eleventh via V11 is configured such that a subsequently formed data signal line is connected with the second auxiliary data line 452 through the via. In an exemplary embodiment, the eleventh via V11 may include a plurality, and the plurality of eleventh vias V11 may be sequentially arranged in the second direction Y to increase reliability of a connection between the data signal line and the second auxiliary data line 452.

In an exemplary embodiment, a twelfth via V12 may be provided in each sub-pixel, an orthographic projection of the twelfth via V12 on the base substrate is within a range of an orthographic projection of the first auxiliary data line 451 on the base substrate, and the third insulating layer, the second insulating layer, and the first insulating layer within the twelfth via V12 are etched off to expose a surface of the first auxiliary data line 451. In an exemplary embodiment, the twelfth via V12 is configured such that a subsequently formed data signal line is connected with the first auxiliary data line 451 through the via.

In an exemplary embodiment, a thirteenth via V13 may be disposed between the second sub-pixel P2 and the third sub-pixel P3, an orthographic projection of the thirteenth via V13 on the base substrate is within a range of an orthographic projection of the compensation connection line 35 on the base substrate, and the third insulating layer, the second insulating layer, and the first insulating layer within the thirteenth via V13 are etched off to expose a surface of the compensation connection line 35. In an exemplary embodiment, the thirteenth via V13 is configured such that a subsequently formed compensation signal line is connected with the compensation connection line 35 through the via.

(27) A pattern of a fifth conductive layer is formed. In an exemplary embodiment, forming a fifth conductive layer may include: depositing a fifth conductive thin film on the base substrate on which the above-mentioned patterns are formed, patterning the fifth conductive thin film using a patterning process to form a fifth conductive layer disposed on the third insulating layer, the fifth conductive layer including at least a first power supply line 21, a compensation signal line 22, a data signal line 25, a gate transfer connection electrode 26, a first transfer connection electrode 46, a second transfer connection electrode 47, a third transfer connection electrode 48, a fourth transfer connection electrode 411, and a fifth transfer connection electrode 412, as shown in FIGS. 20a and 20b, where FIG. 20b is a schematic plan view of the fifth conductive layer in FIG. 20a. In an exemplary embodiment, the fifth conductive layer may be referred to as a Source Drain metal (SD) layer.

In the exemplary embodiment, the first power supply line 21 is respectively provided in the first sub-pixel P1 and the fourth sub-pixel P4 and a main body portion of a first power supply line 21 extends along the second direction Y. On the one hand, the first power supply line 21 is connected to the first region 32-1 of the second active layer 32 through the third via V3 to enable writing of a power supply signal to the second transistor T2, on the other hand, the first power supply line 21 is connected to the first power supply auxiliary line 44 through a plurality of seventh vias V7, so that the first power supply line 21 and the first power supply auxiliary line 44 form a double-layer trace, and on the other hand, the first power supply line 21 is connected to the first power supply connection line 43 through the third via V3, so that the first power supply connection line 43 can transmit the power supply signal to the second sub-pixel P2 and the third sub-pixel P3, respectively.

In the exemplary embodiment, a data signal line 25 is provided at each sub-pixel, respectively, and a main body portion of a data signal line 25 extends in the second direction Y. On the one hand, the data signal line 25 is connected to the first region 31-1 of the first active layer 31 through the first via V1 to enable the data signal to be written to the first transistor T1, on the other hand, the data signal line 25 is connected to the second auxiliary data line 452 through the plurality of eleventh vias V11, so that the data signal line 25 and the second auxiliary data line 452 form a double-layer trace, and on the other hand, the data signal line 25 is connected to the first auxiliary data line 451 through a plurality of twelfth vias V12, so that the data signal line 25, the first auxiliary data line 451 and the second auxiliary data line 452 form a three-layer trace.

In the exemplary embodiment, the compensation signal line 22 is provided between the second sub-pixel P2 and the third sub-pixel P3, and a main body portion of a compensation signal line 22 extends in the second direction Y. The compensation signal line 22 is connected to the compensation connection line 35 through the thirteenth via V13, and is connected to a first region of an active layer of the third transistor T3 through the fifth via V5. The compensation signal line 22 is arranged to write a compensation signal to the third transistor T3. In an exemplary embodiment, the compensation signal line 22 may serve as a first electrode of the third transistor T3. In an embodiment of the present disclosure, an orthographic projection of the compensation signal line 22 on the base substrate at least partially overlaps orthographic projections of first regions of two adj acent third transistors T3 on the base substrate, the two adj acent third transistors T3 can share the first electrode, the layout space is effectively utilized, and the space of the display substrate can be saved.

In an exemplary embodiment, a gate transfer connection electrode 26 is provided at each sub-pixel, and the gate transfer connection electrode 26 may be of a rectangular structure. The gate transfer connection electrode 26 is connected to the first gate electrode 49 and the first scan signal auxiliary line 410 through the ninth via V9.

In an exemplary embodiment, a first transfer connection electrode 46 is formed in each sub-pixel, an orthographic projection of the first transfer connection electrode 46 on the base substrate at least partially overlaps an orthographic projection of the second region 31-2 of the active layer 31 of the first transistor T1 on the base substrate, and the first transfer connection electrode 46 is configured to be connected to the second region 31-2 of the active layer 31 of the first transistor T1 through the second via V2. In an exemplary implementation mode, the first transfer connection electrode 46 may serve as the second electrode of the first transistor T1.

In the exemplary embodiment, a second transfer connection electrode 47 is formed in each sub-pixel, an orthographic projection of the second transfer connection electrode 47 on the base substrate, on the one hand, at least partially overlaps an orthographic projection of the second region 32-2 of the active layer 32 of the second transistor T2 on the base substrate, and on the other hand, at least partially overlaps an orthographic projection of the shield structure 23 on the base substrate, the second transfer connection electrode 47 is configured to be connected to the second region 32-2 of the active layer 32 of the second transistor T2 and the shield structure 23 through the second via V4. In an exemplary implementation mode, the second transfer connection electrode 47 may serve as a second electrode of the second transistor T2.

In an exemplary implementation mode, a third transfer connection electrode 48 is formed in each sub-pixel, an orthographic projection of the third transfer connection electrode 48 on the base substrate at least partially overlaps an orthographic projection of the second region 33-2 of the active layer 33 of the third transistor T3 on the base substrate, and the third transfer connection electrode 48 is configured to be connected to the second region 33-2 of the active layer 33 of the third transistor T3 through the sixth via V6. In an exemplary implementation mode, the third transfer connection electrode 48 may serve as a second electrode of the third transistor T3.

In an exemplary implementation mode, a fourth transfer connection electrode 411 is provided in the first sub-pixel P1 and the fourth sub-pixel P4, an orthographic projection of the fourth transfer connection electrode 411 on the base substrate, on the one hand, at least partially overlaps with an orthographic projection of the first region 33-1 of the active layer 33 of the third transistor T3 on the base substrate, and on the other hand, at least partially overlaps with an orthographic projection of the compensation connection line 35 on the base substrate, the fourth transfer connection electrode 411 is provided to be connected to the active layer 33 of the third transistor T3 through the fifth via V5 and to the compensation connection line 35 through the eighth via V8, and the fourth transfer connection electrode 411 may serve as a first electrode of the third transistor T3.

In an exemplary implementation mode, a fifth transfer connection electrode 412 is provided at each sub-pixel, an orthographic projection of the fifth transfer connection electrode 412 on the base substrate at least partially overlaps, on the one hand, an orthographic projection of the second gate electrode 42 on the base substrate, and on the other hand, at least partially overlaps an orthographic projection of the second electrode plate 34 on the base substrate, and the fifth transfer connection electrode 412 is provided to be connected to the second gate electrode 42 and the second electrode plate 34 through the tenth via V10.

The exemplary embodiment of the present disclosure achieves writing power supply signals to the second transistors T2 of four sub-pixels respectively by providing two first power supply lines 21 extending along the second direction Y and one power supply connection lines 43 extending along the first direction X. In the first sub-pixel P1 and the fourth sub-pixel P4, the first power supply lines 21 are directly connected to the second transistors T2 through a via, respectively. In the second sub-pixel P2 and the third sub-pixel P3, the first power supply line 21 is connected to the second transistor T2 through the power supply connection line 43, respectively.

The exemplary embodiment of the present disclosure achieves writing compensation signals to the third transistors T3 of four sub-pixels respectively by providing one compensation signal line 22 having its main body portion extending along the second direction Y and one compensation connection lines 35 extending along the first direction X. In the second sub-pixel P2 and the third sub-pixel P3, the compensation signal lines 22 are directly connected to the third transistors T3 through a via, respectively. In the first sub-pixel P1 and the fourth sub-pixel P4, the compensation signal lines 21 are connected to the third transistors T3 through the compensation connection line 35 respectively. The present invention provides compensation signals to four sub-pixels by providing a compensation signal line, which can ensure that the RC delay of the compensation signals is basically the same before being written into the transistor, thus ensuring the uniformity of the display.

Exemplary embodiments of the present disclosure enable writing data signals to the first transistors T1 of four sub-pixels respectively by providing data signal lines 25 extending along the second direction Y in each sub-pixel, the data signal lines 25 is connected to the first transistors T1 of the sub-pixels through vias.

In an exemplary embodiment, the first power supply line 21, the data signal line 25 and the compensation signal line 22 may be straight or polylines of equal or unequal widths. The first power supply line 21, the data signal line 25 and the compensation signal line 22 are straight or polylines with variable widths, which not only facilitates the layout of the pixel structure, but also reduces parasitic capacitance.

(28) Patterns of a fourth insulating layer and a planarization layer are formed. In an exemplary embodiment, forming a pattern of a planarization layer may include coating a fourth insulating layer film and a planarization thin film on the base substrate on which the above-mentioned patterns are formed, patterning the fourth insulating layer film and the planarization thin film using a patterning process to form a fourth insulating layer and a pattern of a planarization layer covering the fifth conductive layer, the fourth insulating layer and the planarization layer are provided with a plurality of vias, and the plurality of vias include at least a twentieth via V20 and a twenty-first via V21 located in each sub-pixel, as shown in FIG. 21.

In an exemplary implementation mode, a twentieth via V20 may be provided in each sub-pixel, an orthographic projection of the twentieth via V20 on the base substrate is within a range of an orthographic projection of the third transfer connection electrode 48 on the base substrate, and the planarization layer and the fourth insulating layer within the twentieth via V20 are removed to expose a surface of the third transfer connection electrode 48. In an exemplary embodiment, the twentieth via V20 is configured such that a subsequently formed anode is connected with the third transfer connection electrode 48 through the via.

In an exemplary implementation mode, a twenty-first via V21 may be provided in each sub-pixel, an orthographic projection of the twenty-first via V21 on the base substrate is within a range of an orthographic projection of the second transfer connection electrode 47 on the base substrate, and the planarization layer and the fourth insulating layer within the twenty-first via V21 are removed to expose a surface of the second transfer connection electrode 47. In an exemplary embodiment, the twenty-first via V21 is configured so that the anode formed subsequently is connected to the second transfer connection electrode 47 through the via.

In an embodiment of the present disclosure, the fourth insulating layer and the pattern of the planarization layer are formed by a single patterning process, which simplifies the process, reduces the preparation cost, and improves the preparation efficiency.

So far, a drive circuit layer has been prepared on the base substrate. In a plane parallel to the display substrate, the drive circuit layer may include multiple sub-pixels, each sub-pixel may include a pixel drive circuit, and a first scan signal line, a first power supply line, a data signal line, and a compensation signal line connected to the pixel drive circuit. In a plane perpendicular to the display substrate, the drive circuit layer may include a first conductive layer, a second conductive layer, a third conductive layer, a first insulating layer, a semiconductor layer, a second insulating layer, a fourth conductive layer, a third insulating layer, a fifth conductive layer, a fourth insulating layer, and a planarization layer sequentially stacked on the base substrate.

In an exemplary embodiment, after the preparation of the drive circuit layer is completed, a light emitting structure layer is prepared on the drive circuit layer, and the preparation process of the light emitting structure layer may include the following acts:
(29) A pattern of a sixth conductive layer is formed. In an exemplary embodiment, forming a pattern of a sixth conductive layer may include depositing a sixth conductive thin film on the base substrate on which the above-mentioned patterns are formed, patterning the sixth conductive thin film using a patterning process to form a pattern of a sixth conductive layer disposed on the planarization layer, the pattern of the sixth conductive layer including at least an anode 301 located in each sub-pixel, as shown in FIGS. 22a and 22b, where FIG. 22b is a schematic plan view of the sixth conductive layer in FIG. 22a. In an exemplary embodiment, the sixth conductive layer may be referred to as a second transparent (ITO2) layer.

In an exemplary implementation mode, the second transparent layer may serve as the transparent conductive layer described above.

In an exemplary implementation mode, the pattern of the sixth conductive layer may include a first anode 301R located in the first sub-pixel P1, a second anode 301W located in the second sub-pixel P2, a third anode 301G located in the third sub-pixel P3, and a fourth anode 301B located in the fourth sub-pixel P4. An anode 301 in each sub-pixel is connected to a third transfer connection electrode 48 through a twentieth via V20. Since the third transfer connection electrode 48 servers as a second electrode of the third transistor T3, the connection of the anode 301 with the third transistor T3 is realized. An anode 301 in each sub-pixel is connected to a second transfer connection electrode 47 through a twenty-first via V21. Since the second transfer connection electrode 47 is used as the second electrode of the second transistor T2, the connection of the anode 301 with the second transistor T2 is implemented.

In an embodiment of the present disclosure, by electrically connecting the anode 301 in the sixth conductive layer to the second electrodes of the second transistor T2 and the third transistor T3, the layout space is effectively utilized, the space of the display substrate can be saved, and the light emission area of the pixel unit in the bottom emission display substrate is increased.

In an exemplary implementation mode, the first anode 301R, the second anode 301W, the fourth anode 301B, and the third anode 301G may be in a shape of a strip extending in the second direction Y. In the second direction Y, a first connection electrode 3011 and a second connection electrode 3012 are respectively provided on two sides of an anode in each sub-pixel, the first connection electrode 3011 is connected to the third transfer connection electrode 48 through the twentieth via V20, and the second connection electrode 3012 is electrically connected to the second transfer connection electrode 47 through the twenty-first via V21. The anode and the first connection electrode 3011 and the second connection electrode 3012 in each sub-pixel may be of an integrally formed structure.

In an exemplary implementation mode, an orthographic projection of an anode in each sub-pixel on the base substrate contains an orthographic projection of a storage capacitor in a sub-pixel where the anode is located on the base substrate.

In an exemplary implementation mode, the twentieth via V20 may serve as the above-described second transfer via, and the twenty-first via V21 may serve as the above-described first transfer via.

(210) A pattern of a pixel definition layer is formed. In an exemplary embodiment, forming the pixel definition layer pattern may include: coating a pixel define film on the base substrate on which the aforementioned patterns are formed, and patterning the pixel define film through a patterning process to form a pattern of a pixel definition layer 302 including at least a pixel opening in each sub-pixel, as shown in FIGS. 23a and 23b, where FIG. 23b is a schematic plan view of the pixel definition layer in FIG. 23a.

In an exemplary embodiment, the pattern of pixel definition layer 302 may include a red pixel opening 302R in the first sub-pixel P1 exposing the red anode 301R, a white pixel opening 302W in the second sub-pixel P2 exposing the white anode 301W, a green opening 302G in the third sub-pixel P3 exposing the green anode 301G, and a blue pixel opening 302B in the fourth sub-pixel P4 exposing the blue anode 301B.

In an exemplary embodiment, the shape and area of the pixel openings of different sub-pixels may be different. In the exemplary embodiment of the present disclosure, four sub-pixels are designed with different aperture ratios, transmittances of color film layers of different sub-pixels may be adapted, so that light emitting devices of the four sub-pixels may emit same brightness at different currents, service life of the light emitting devices of the four sub-pixels is optimized to a maximum extent, and thereby ensuring service life of a product.

In an exemplary embodiment, an orthographic projection of a pixel opening in each sub-pixel on the base substrate at least partially overlaps an orthographic projection of a storage capacitor of the sub-pixel on the base substrate.

In an exemplary implementation mode, a subsequent manufacturing process may include: forming an organic emitting layer using an evaporation or inkjet printing process, wherein the organic emitting layer is connected with an anode through a pixel opening, and forming a cathode on the organic emitting layer, wherein the cathode is connected with the organic emitting layer. An encapsulation layer is formed, wherein the encapsulation layer may include a first encapsulation layer, a second encapsulation layer, and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer to ensure that external water vapor cannot enter the light emitting structure layer.

In some exemplary embodiments, the first conductive layer and the sixth conductive layer may be made of a transparent conductive material, such as Indium Tin Oxide (ITO) and Indium Zinc Oxide (IZO). The second conductive layer, the third conductive layer, the fourth conductive layer and the fifth conductive layer may be made of metal materials, such as any one or more of silver (Ag), copper (Cu), aluminum (Al) and molybdenum (Mo), or alloy materials of the above metals, such as an aluminum neodymium alloy (AlNd) or a molybdenum niobium alloy (MoNb), and may be a single-layer structure or a multi-layer composite structure, such as Mo/Cu/Mo, etc. The first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer. The first insulation layer is referred to as a buffer layer, the second insulation layer is referred to as a Gate Insulator (GI) layer, the third insulation layer is referred to as an Interlayer Dielectric (ILD) layer, and the fourth insulation layer is referred to as a Passivation (PVX) layer. The planarization layer may be made of an organic material such as resin. The pixel definition layer may be made of polyimide, acrylic or polyethylene terephthalate.

The RC of the data signal line and the scan signal line is the main limiting factor for the realization of the refresh frequency of the display substrate, so reducing their RC is also a major requirement for the layout design of the display substrate. The display substrate obtained by the preparation method in the above acts (21) to (210) transmits a signal of the first scan line through the second shield metal layer, and increases its distance from the source-drain metal layer to reduce the capacitance of the first scan signal line. In an exemplary implementation mode, the first shield metal layer adopts a thick Cu trace, which can reduce a resistance of the first scan signal line. In order to prevent the thick first shield metal layer from cutting off the active layer at the edge position where the first shield metal layer and the active layer overlap, the shield metal layer is deposited twice using a double-layer design. The first scan signal line partially adopts a thicker first shield metal layer, and the shield structure adopts a thinner second shield metal layer. In an embodiment of the present disclosure, the data signal line adopts a three-layer structure of the second shield metal layer, the gate metal layer, and the source-drain metal layer SD, so as to reduce the RC of the data signal line and make it reach the realization standard of the refresh frequency. The shield metal layer, gate metal layer, and source-drain metal layer can be made of copper, which reduces impedance and is compatible with large-size design. In the display substrate according to the embodiment of the present disclosure, the data signal line adopts a three-layer trace structure of a source-drain metal layer SD/a gate metal layer GT/a second shield metal layer SHIELD, the first power supply line VDD adopts a double-layer trace structure of a source-drain metal layer SD/a gate metal layer GT, and the first scan signal line adopts a double-layer trace structure of a first shield layer and a second shield metal layer, which can reduce the load on the data signal line, the first power supply line and the first scan signal line, and provide technical support for medium- and large-size display substrates with high PPI.

In an exemplary implementation mode, the capacitor in the above-described display substrate may adopt a transparent capacitor, that is, the first electrode plate and the second electrode plate may be of a transparent structure, thereby improving the aperture ratio and PPI of the display substrate. In the display substrate prepared in acts (11) to (18) and (21) to (210), the two electrodes of the capacitor in the sub-pixel are located in the first conductive layer and the semiconductor layer, the first electrode plate 11 and the second electrode plate 34 are both of a transparent structure, and the two electrodes of the capacitor do not take up the aperture ratio. Moreover, by connecting a second electrode of the second transistor T2 and a second electrode of the third transistor T3 through the transparent conductive layer 300, the trace connecting the two transistors does not take up the aperture ratio, the shield of the pixel opening 302 can be avoided, the light emission area can be increased, and the aperture ratio and PPI of the display substrate can be improved.

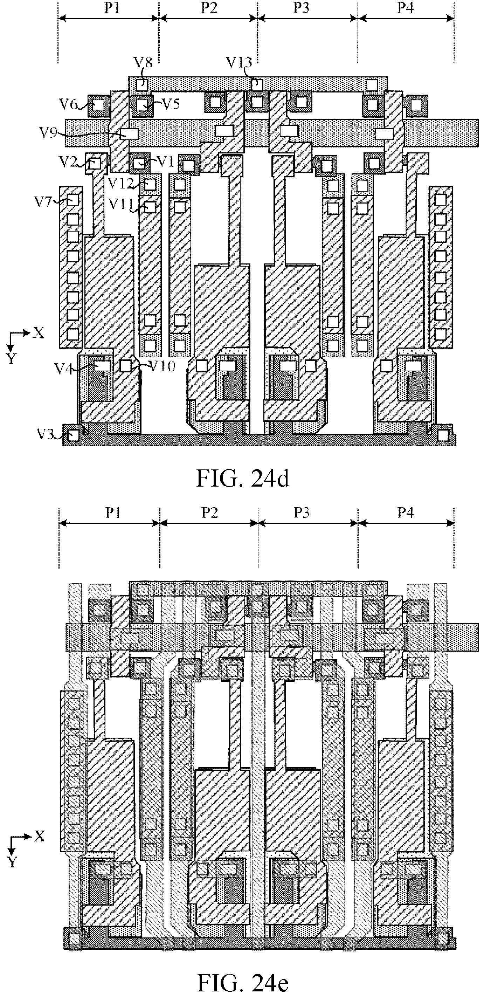

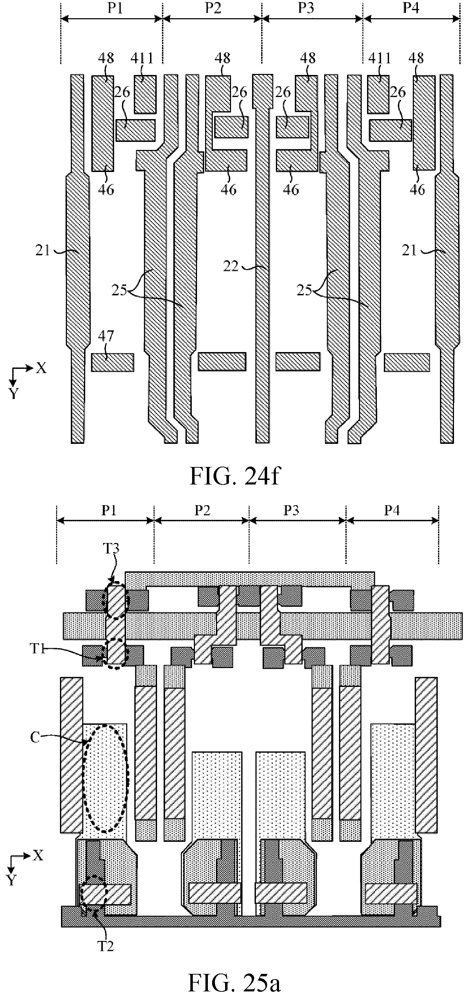

In other implementation modes, the pattern of the semiconductor layer formed in the above act (24) may be as shown in FIG. 24a, that is, the second electrode plate 34 of the capacitor is not provided in the semiconductor layer; a diagram of a planar structure after the pattern of the fourth conductive layer is formed in the above act (25) can be as shown in FIG. 24b, the pattern of the fourth conductive layer in FIG. 24b can be as shown in FIG. 24c, the second electrode plate 34 of the capacitor is provided in the fourth conductive layer, an orthographic projection of the second electrode plate 34 on the base substrate and an orthographic projection of the first electrode plate 11 on the base substrate have an overlapping region, and the second electrode plate 34 and the second gate electrode 42 can be of an integrally formed structure; the pattern of the third insulating layer formed in the above act (26) can be as shown in FIG. 24d, which differs from FIG. 19 in that the third insulating layer in the second via V2 and the tenth via V10 is etched off to expose a surface of the second electrode plate 34; a structural diagram after the fifth conductive layer is formed in the above act (27) can be as shown in FIG. 24e, and a schematic diagram of a planar structure of the fifth conductive layer in FIG. 24e can be as shown in FIG. 24f. The difference between FIGS. 24e and 24f and FIGS. 20a and 20b is that the first transfer connection electrode 46 and the third transfer connection electrode 48 can be of an integrally formed structure so as to electrically connect the second electrode plate 34 to a second electrode of the third transistor T3 via the first transfer connection electrode 46 and the third transfer connection electrode 48, to realize that a second electrode of the third transistor T3 are electrically connected to the second electrode plate 34; the second transfer connection electrode 47 may also be electrically connected to the second electrode plate 34 through the tenth via V10, thereby realizing the electric connection between a second electrode of the second transistor T2 and the second electrode plate 34. The structures of the pattern of the first conductive layer to the pattern of the third conductive layer are the same as those in the above acts (21) to (23), and the pattern the fourth insulating layer and the pattern of the planarization layer, the pattern of the sixth conductive layer, and the pattern of the pixel definition layer are the same as those in the above acts (28) to (210), which will not be described in detail in the embodiment of the present disclosure. In an embodiment of the present disclosure, two electrode plates of the capacitor are transparent structures arranged on the first conductive layer and the fourth conductive layer, which can avoid the shield of the pixel opening 302, and improve the aperture ratio and PPI of the display substrate.

In other implementation modes, the pattern of the semiconductor layer formed in the above act (24) may be as shown in FIG. 24a, that is, the second electrode plate 34 of the capacitor is not provided in the semiconductor layer; a diagram of a planar structure after the pattern of the fourth conductive layer is formed in the above act (25) may be as shown in FIG. 25a, and the pattern of the fourth conductive layer in FIG. 25a may be the same as the structure as shown in FIG. 18b; a schematic diagram of a planar structure after the pattern of the fifth conductive layer is formed in the above act (27) may be as shown in FIG. 25b, and a schematic diagram of a planar structure of the pattern of the fifth conductive layer in FIG. 25b may be as shown in FIG. 20b; a schematic diagram of a planar structure after the pattern of the sixth conductive layer is formed in the above act (29) may be as shown in FIG. 25c, and a schematic diagram of a planar structure of the sixth conductive layer in FIG. 25c may be as shown in FIG. 22b. In an embodiment of the present disclosure, the difference from the above acts (21) to (210) is that the second electrode plate 34 of the capacitor in the semiconductor layer is removed, and the anode 301 is reused as the second electrode plate of the capacitor, that is, the semiconductor layer formed is different from that in the above act (24), and the other structural film layers are the same as those in the above acts (21) to (23) and (25) to 210. In an embodiment of the present disclosure, the transparent conductive layer 300 is reused as the second electrode plate of the capacitor, and a second electrode of the second transistor T2 and a second electrode of the third transistor T3 are connected via the transparent conductive layer, so that the layout space can be saved, and the aperture ratio and PPI of the display substrate can be improved.

In the technical scheme according to an embodiment of the present disclosure, since the first connection via V21 and the second connection via V20 are located at two sides of the pixel opening 302, the problem of uneven display caused by one pixel opening being located at one side of the pixel opening 302 can be avoided.

The structure and its preparation process shown in the present disclosure are only an exemplary illustration. In an exemplary implementation mode, the corresponding structure can be changed and the patterning process can be increased or decreased according to actual needs; for example, the display region may include 3 sub-pixels. For another example, the pixel drive circuit may be 5T1C or 7T1C and the like and the present disclosure is not limited herein.

In an exemplary implementation mode, the display substrate according to the present disclosure may be applied to a display apparatus with a pixel drive circuit, such as an OLED, a quantum dot display (QLED), a light emitting diode display (Micro LED or Mini LED), or a Quantum Dot Light Emitting Diode display (QDLED), which is not limited here in the present disclosure.

The present disclosure also provides a display apparatus which includes the display substrate according to the aforementioned embodiments. The display apparatus may be any product or component with a display function, such as a mobile phone, a tablet computer, a television, a display, a laptop computer, a digital photo frame, and a navigator.

For the display substrate, the preparation method therefor and the display apparatus provided by the present embodiment, a second electrode of the second transistor and a second electrode of the third transistor located in a same sub-pixel of the display substrate are electrically connected by at least one transparent conductive layer, the transparent conductive layer does not shield an opening, which can improve the aperture ratio and PPI of the display substrate.

Although the implementations of the present disclosure are disclosed above, the contents are only implementations used for ease of understanding of the present disclosure, but not intended to limit the present disclosure. Those skilled in the art may make any modification and change in the forms and details of the implementations without departing from the essence and scope of the present disclosure. However, the scope of protection of the present disclosure should still be subject to the scope defined by the attached claims.

## Claims

1. A display substrate comprising a base substrate, a plurality of sub-pixels and a plurality of transparent conductive layers provided on the base substrate, each sub-pixel comprising at least one transparent conductive layer, at least a portion of the sub-pixels comprising at least a second transistor and a third transistor, a second electrode of the second transistor and a second electrode of the third transistor located in a same sub-pixel being electrically connected through at least one transparent conductive layer.

2. The display substrate according to claim 1, wherein at least a portion of the transparent conductive layers comprise an anode, a first connection electrode, and a second connection electrode, wherein the anode is electrically connected to the first connection electrode and the second connection electrode in a same transparent conductive layer;
in a same sub-pixel, a second electrode of the second transistor is electrically connected with a corresponding anode through the first connection electrode, a second electrode of the third transistor is electrically connected with a corresponding anode through the second connection electrode, and the second electrode of the second transistor and the second electrode of the third transistor are electrically connected through a corresponding first connection electrode, second connection electrode, and anode.

3. The display substrate according to claim 2, wherein the first connection electrode and the second connection electrode are of an integrally formed structure with a corresponding anode.

4. The display substrate according to claim 2, further comprising a pixel definition layer, wherein the pixel definition layer is located on a side of the transparent conductive layer away from the base substrate, wherein the pixel definition layer is formed with a plurality of pixel openings, each sub-pixel comprises at least one pixel opening, wherein an orthographic projection of the pixel opening on the base substrate and an orthographic projection of a corresponding anode on the base substrate have an overlapping region, and the transparent conductive layer is located in a light emitting region of a corresponding sub-pixel.

5. The display substrate according to claim 4, wherein the second electrode of the second transistor is electrically connected to a corresponding first connection electrode through a first transfer via, and an orthographic projection of the first transfer via on the base substrate is within a range of an orthographic projection of the first connection electrode on the base substrate; the second electrode of the third transistor is electrically connected to a corresponding second connection electrode through a second transfer via, and an orthographic projection of the second transfer via on the base substrate is within a range of an orthographic projection of the second connection electrode on the base substrate; a closest distance from the first transfer via to an edge of a corresponding pixel opening is less than a closest distance from the second transfer via to an edge of the corresponding pixel opening, and the first transfer via and the second transfer via are located at two sides of the corresponding pixel opening.

6. The display substrate according to claim 5, wherein the plurality of sub-pixels are arranged in a row direction and a column direction, in the row direction, a distance between first transfer vias in two adjacent sub-pixels comprises a first distance and a second distance, the first distance being greater than the second distance, the first distance and the second distance being arranged alternately in the row direction.

7. The display substrate according to claim 6, wherein, in the row direction, a distance between second transfer vias in adjacent two sub-pixels comprises a third distance and a fourth distance, the third distance being greater than the fourth distance, the third distance and the fourth distance being arranged alternately in the row direction.

8. The display substrate according to claim 6, wherein in a same sub-pixel, the second transistor and the third transistor are located at two sides of a corresponding anode in the column direction, and a distance between the second transistor and the third transistor is greater than 0.5 times a size of a sub-pixel in the column direction.

9. The display substrate according to claim 2, further comprising a plurality of data signal lines and a plurality of auxiliary data lines, wherein the plurality of data signal lines are electrically connected to the plurality of auxiliary data lines respectively, the data signal lines and the auxiliary data lines are located on different conductive layers, and in a direction perpendicular to a plane where the display substrate is located, conductive layers where the data signal lines and the auxiliary data lines are located are located between the base substrate and the transparent conductive layers, and orthographic projections of the plurality of data signal lines on the base substrate are at least partially overlapped with orthographic projections of the plurality of auxiliary data lines on the base substrate respectively.

10. The display substrate according to claim 9, wherein the display substrate comprises a gate metal layer disposed on the base substrate, and at least a portion of the auxiliary data lines are located on the gate metal layer.

11. The display substrate according to claim 10, wherein the display substrate further comprises a shield metal layer, wherein the gate metal layer is located on a side of the shield metal layer away from the base substrate in the direction perpendicular to the plane where the display substrate is located, and the plurality of data signal lines are located on the shield metal layer.

12. The display substrate according to claim 11, wherein the shield metal layer is further provided with a plurality of first power supply lines, the gate metal layer is further provided with a plurality of first power supply auxiliary lines, the plurality of first power supply lines are respectively electrically connected with the plurality of first power supply auxiliary lines, and orthographic projections of the plurality of first power supply lines on the base substrate are at least partially overlapped with orthographic projections of the plurality of first power supply auxiliary lines on the base substrate respectively.

13. The display substrate according to claim 12, wherein the plurality of sub-pixels form a plurality of pixel units arranged in an array, each pixel unit comprises at least three sub-pixels, the gate metal layer is also provided with a plurality of first power supply connection lines, two first power supply auxiliary lines are comprised in a same pixel unit, two ends of a first power supply connection line located in a same pixel unit are respectively connected with the two first power supply auxiliary lines, on a plane parallel to the display substrate, a main body portion of a first power supply auxiliary line extends in a second direction, a main body portion of a first power supply connection line extends in a first direction, and the first direction intersects the second direction.

14. The display substrate according to claim 11, wherein the display substrate further comprises a semiconductor layer, the semiconductor layer is located on a side of the shield metal layer away from the base substrate in the direction perpendicular to the plane where the display substrate is located, the semiconductor layer is provided with a plurality of compensation connection lines, the shield metal layer is further provided with a plurality of compensation signal lines, and on a plane parallel to the display substrate, a compensation connection line is in a structure of a strip extending in a first direction, a compensation signal line is in a structure of a strip extending in a second direction, the first direction intersects the second direction, and a compensation connection line is electrically connected with at least one compensation signal line.

15. The display substrate according to claim 9, wherein the display substrate further comprises a source-drain metal layer located on a side of the gate metal layer away from the base substrate in a direction perpendicular to the plane where the display substrate is located, and the plurality of data signal lines are located on the source-drain metal layer.

16. The display substrate according to claim 15, wherein the display substrate further comprises a second shield metal layer located between the base substrate and the gate metal layer in a direction perpendicular to the plane where the display substrate is located, the plurality of auxiliary data lines comprise a plurality of first auxiliary data lines and a plurality of second auxiliary data lines, the plurality of first auxiliary data lines are located on the second shield metal layer, the plurality of second auxiliary data lines are located on the gate metal layer, orthographic projections of the plurality of first auxiliary data lines and the plurality of second auxiliary data lines on the base substrate and orthographic projections of a corresponding plurality of data signal lines on the base substrate have overlapping regions, and the plurality of first auxiliary data lines and the plurality of second auxiliary data lines are electrically connected with the corresponding plurality of data signal lines.

17. The display substrate according to claim 16, wherein the source-drain metal layer is further provided with a plurality of first power supply lines, the gate metal layer is further provided with a plurality of first power supply auxiliary lines, the plurality of first power supply lines are respectively electrically connected with the plurality of first power supply auxiliary lines, and orthographic projections of the plurality of first power supply lines on the base substrate are at least partially overlapped with orthographic projections of the plurality of first power supply auxiliary lines on the base substrate.

18. The display substrate according to claim 17, wherein the plurality of sub-pixels form a plurality of pixel units arranged in an array, each pixel unit comprises at least three sub-pixels, the display substrate further comprises a semiconductor layer, in a direction perpendicular to the plane where the display substrate is located, the semiconductor layer is located on a side of the second shield metal layer away from the base substrate, the semiconductor layer is provided with a plurality of first power supply connection lines, two first power supply lines are comprised in a same pixel unit, two ends of a first power supply connection line located in a same pixel unit are respectively electrically connected with the two first power supply lines, and in a plane parallel to the display substrate, a main body portion of a first power supply line extends in a second direction, a main body portion of the first power supply connection lines extends in a first direction, and the first direction intersects the second direction.

19. The display substrate according to claim 16, wherein the second shield metal layer is further provided with a plurality of compensation connection lines, and the source-drain metal layer is further provided with a plurality of compensation signal lines, on a plane parallel to the display substrate, a compensation connection line is in a structure of a strip extending in a first direction, a compensation signal line is in a structure of a strip extending in a second direction, the first direction intersects the second direction, and a compensation connection line is electrically connected to at least one compensation signal line.

20. The display substrate according to claim 16, wherein the display substrate further comprises a first shield metal layer located between the base substrate and the second shield metal layer in a direction perpendicular to the plane where the display substrate is located, wherein the first shield metal layer is provided with a plurality of first scan signal lines, the second shield metal layer is provided with a plurality of first scan signal auxiliary lines electrically connected with the plurality of first scan signal lines respectively, and orthographic projections of the plurality of first scan signal lines on the base substrate are at least partially overlapped with orthographic projections of the plurality of first scan signal auxiliary lines on the base substrate, respectively.

21. The display substrate according to claim 20, wherein a thickness of the first shield metal layer is greater than a thickness of the second shield metal layer.

22. The display substrate according to claim 2, further comprising a first conductive layer located between the base substrate and the transparent conductive layer, a sub-pixel further comprises a capacitor, the first conductive layer comprises a first electrode plate of the capacitor, the first electrode plate has a transparent structure, the anode is reused as a second electrode plate of the capacitor, in a same sub-pixel, an orthographic projection of the first electrode plate on the base substrate and an orthographic projection of the second electrode plate on the base substrate have a first overlapping region, and the first overlapping region is located in a light emitting region of the sub-pixel.

23. The display substrate according to claim 1, further comprising a first conductive layer located between the base substrate and the transparent conductive layer, a sub-pixel further comprises a capacitor, the first conductive layer comprises a first electrode plate of the capacitor, the first electrode plate has a transparent structure;
the display substrate further comprises a gate metal layer, wherein the transparent conductive layer is located in the gate metal layer, and the transparent conductive layer is reused as a second electrode plate of the capacitor, wherein an orthographic projection of the first electrode plate on the base substrate and an orthographic projection of the second electrode plate on the base substrate have a first overlapping region, wherein the first overlapping region is located in a light emitting region of the sub-pixel.

24. A display apparatus, comprising the display substrate according to any one of claims 1-23.

25. A preparation method for a display substrate, comprising: forming a plurality of sub-pixels and a plurality of transparent conductive layers on a side of a base substrate, wherein at least a portion of the sub-pixels comprise at least a second transistor and a third transistor, and a second electrode of the second transistor and a second electrode of the third transistor located in a same sub-pixel are electrically connected through at least one transparent conductive layer.
